(19) Europäisches Patentamt / European Patent Office / Office européen des brevets

(11) **EP 3 117 229 B1**

(12) **EUROPEAN PATENT SPECIFICATION**

(45) Date of publication and mention
of the grant of the patent:
**26.12.2018 Bulletin 2018/52**

(21) Application number: **15713602.9**

(22) Date of filing: **13.03.2015**

(51) Int Cl.:
**G05B 15/02** (2006.01)          **H04R 25/00** (2006.01)
**G01R 31/36** (2006.01)          **H02J 50/00** (2016.01)
**H02J 7/00** (2006.01)

(86) International application number:
**PCT/US2015/020328**

(87) International publication number:
**WO 2015/138828 (17.09.2015 Gazette 2015/37)**

(54) **BATTERY CHARGER COMMUNICATION SYSTEM**

BATTERIELADEVORRICHTUNGSKOMMUNIKATIONSSYSTEM

SYSTÈME DE COMMUNICATION DE CHARGEUR DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.03.2014   US 201461953523 P**

(43) Date of publication of application:
**18.01.2017   Bulletin 2017/03**

(73) Proprietor: **ZPower, LLC
Camarillo, CA 93012 (US)**

(72) Inventors:
• **RENKEN, Troy, W.
Alpharetta, GA 30022 (US)**
• **POWERS, Timothy, W.
Thousand Oaks, CA 91362 (US)**

(74) Representative: **Cohausz & Florack
Patent- & Rechtsanwälte
Partnerschaftsgesellschaft mbB
Bleichstraße 14
40211 Düsseldorf (DE)**

(56) References cited:
**WO-A1-2008/024748          GB-A- 1 465 240
US-A1- 2012 130 660          US-A1- 2013 173 190**

**Description**

TECHNICAL FIELD

This disclosure relates to a battery charger communication system.

BACKGROUND

Many electronic devices require batteries in order to operate. These devices may lack a user interface that can efficiently notify a user of one such device with a state of charge of the battery of the device. For instance, many hearing aids operate on rechargeable silver zinc batteries and most, if not all, do not have a user interface (e.g., an LCD screen). Users of these hearing aids typically need to charge their batteries every day. If the user forgets to charge the batteries, the battery will not have enough capacity to power the hearing aid the following day. This may cause a great inconvenience to the user. Additionally, if a user was aware of the state of charge of the battery, the user may use their hearing aid differently. For example, the user may change a setting which causes the battery to stop using wireless streaming, thereby reducing the draw on the batteries.
The document US 2012/130660 discloses an hearing aid wherein a state of charge of the battery supplying power to the hearing aid is estimated within the hearing aid and then transmitted to an user device for display.

SUMMARY

One aspect of the disclosure provides a method that comprises: (i) receiving, at a processing device, charge data from a charging unit via network; (ii) determining, by the processing device, an average discharge rate of the battery based on previously received charge data corresponding to the battery; (iii) determining, by the processing device, an estimated state of charge of the battery based on the average discharge rate and a current device usage time; and (iv) providing, by the processing device, the estimated state of charge to a user device for display. The charging unit includes a charger and the charge data includes a charge capacity indicating an amount of charge delivered to a battery during a most recent charging session and a device usage time indicating an amount of time that the battery was off the charger during a period preceding the most recent charging session. The current device usage time corresponds to a period after the most recent charging session.
Implementations of the disclosure may include one or more of the following optional features. In some implementations, determining the average discharge rate includes retrieving, at the processing device, N charge records corresponding to the charging unit, and for each of the N charge records, determining a previous average discharge rate based on the previous charge capacity and the previous device usage time of the charging record. The method also includes determining, at the processing device, the average discharge rate of the battery based on the N previous average discharge rates. In some examples each charge record corresponds to a different previous charging session and includes a previous charge capacity of the previous charging session and a previous device usage time corresponding to a period of use directly preceding the previous charging session.
Optionally, determining the estimated state of charge includes: (i) obtaining a fully charged capacity of the battery; (ii) determining an estimated amount of discharge of the battery during the period after the most recent charging session based on the average discharge rate and the current device usage time; and (iii) determining the estimated remaining state of charge based on a difference between the fully charged battery capacity and the estimated amount of discharge. In some implementations, the method also comprises receiving, at the processing device, an event notification indicating a removal time at which the battery was most recently removed from the charger and determining, by the processing device, the current device usage time based on the removal time and a current time. Providing the estimated state of charge may include transmitting the estimated state of charge from the processing device to the user device over the network.
In some implementations, the method further comprises, prior to the step of determining the estimated state of charge, receiving, at the processing device, a charge request from the user device, the estimated state of charge determined and provided by the processing device in response to receiving the charge request. Providing the estimated state of charge optionally includes determining whether the estimated state of charge is below a state of charge threshold, and when the estimated state of charge is below the state of charge threshold, transmitting the estimated state of charge from the processing device to the user device over the network.
Another aspect of the disclosure provides a charge server comprising a network interface device, a storage device, and a processing device coupled to the storage device and the network interface device. The processing device is configured to: (i) receive charge data from a charging unit via network; (ii) determine an average discharge rate of the battery based on previously received charge data corresponding to the battery; (iii) determine an estimated state of charge of the battery based on the average discharge rate and a current device usage time; and (iv) provide the estimated state of charge to a user device for display. The charging unit includes a charger and the charge data includes a charge capacity indicating an amount of charge delivered to a battery during a most recent charging session and a device usage time indicating an amount of time that the battery was off the charger during a period preceding the most recent charging session. The current device usage time corresponds to a period after the most recent charging session.

This aspect may include one or more of the following optional features. The battery may be used in a device that does not have a user interface. The processing device optionally determines the average discharge rate by: (i) retrieving N charge records corresponding to the charging unit; for each of the N charge records; (ii) determining a previous average discharge rate based on the previous charge capacity and the previous device usage time of the charging record; and (iii) determining the average discharge rate of the battery based on the N previous average discharge rates. In some examples each charge record corresponds to a different previous charging session and includes a previous charge capacity of the previous charging session and a previous device usage time corresponding to a period of use directly preceding the previous charging session.

In some implementations, the processing device determines the estimated state of charge by: (i) obtaining a fully charged capacity of the battery; (ii) determining an estimated amount of discharge of the battery during the period after the most recent charging session based on the average discharge rate and the current device usage time; and (iii) determining the estimated remaining state of charge based on a difference between the fully charged battery capacity and the estimated amount of discharge. In some examples, the processing device is further configured to receive an event notification indicating a removal time at which the battery was most recently removed from the charger and determine the current device usage time based on the removal time and a current time. The processing device may provide the estimated state of charge by transmitting the estimated state of charge from the processing device to the user device over the network.

In some implementations, prior to the processing device determines the estimated state of charge in response to receiving a charge request from the user device. The processing device may optionally provide the estimated state of charge by determining whether the estimated state of charge is below a state of charge threshold, and when the estimated state of charge is below the state of charge threshold, transmitting the estimated state of charge from the processing device to the user device over the network.

Another aspect of the disclosure provides a system comprising a battery, a charging unit including a charger and a networked device, and a charge server. The charging unit is configured to charge the battery and to transmit charge data over a network. The charge server is configured to receive the charge data, determine an estimated state of charge of the battery after the battery has been removed from the charger based on the charge data, and transmit the estimated state of charge to a networked user device, the user device displaying the estimated state of charge (130) to a user.

This aspect may include one or more of the following optional features. In some examples, the charge data includes a charge capacity that indicates an amount of charge delivered to a battery during a most recent charging session and the device usage time indicates an amount of time that the battery was off the charger during a period preceding the most recent charging session. The current device usage time corresponds to a period after the most recent charging session. The estimated state of charge may further be based on historical charge data. Optionally, the charge server transmits the estimated state of charge in response to a charge request for the estimated state of charge from the user device and/or when the estimated state of charge is less than a predetermined threshold.

In yet another aspect of the disclosure provides a method comprising: (i) receiving, at a processing device of a user device, charge data from a charging unit via network; (ii) determining an average discharge rate of the battery based on previously received charge data corresponding to the battery; (iii) determining an estimated state of charge of the battery based on the average discharge rate and a current device usage time; and (iv) displaying the estimated state of charge via user interface of the user device. The charging unit includes a charger and the charge data includes a charge capacity indicating an amount of charge delivered to a battery during a most recent charging session and a device usage time indicating an amount of time that the battery was off the charger during a period preceding the most recent charging session. The current device usage time corresponds to a period after the most recent charging session.

Implementations of the disclosure may include one or more of the following optional features. In some implementations, determining the average discharge rate includes retrieving, at the processing device, N charge records corresponding to the charging unit, and for each of the N charge records, determining a previous average discharge rate based on the previous charge capacity and the previous device usage time of the charging record. The method also includes determining, at the processing device, the average discharge rate of the battery based on the N previous average discharge rates. In some examples each charge record corresponds to a different previous charging session and includes a previous charge capacity of the previous charging session and a previous device usage time corresponding to a period of use directly preceding the previous charging session. The battery may be used in a device that does not have a user interface.

Optionally, determining the estimated state of charge includes: (i) obtaining a fully charged capacity of the battery; (ii) determining an estimated amount of discharge of the battery during the period after the most recent charging session based on the average discharge rate and the current device usage time; and (iii) determining the estimated remaining state of charge based on a difference between the fully charged battery capacity and the estimated amount of discharge. In some implementations, the method also comprises receiving, at the processing device, an event notification indicating a removal time at which the battery was most recently removed from the charger and determining, by the processing device, the current device usage time based on the removal time and a current time. Providing the estimated state of charge may include transmitting the estimated state of charge from the processing device to the user device over the network.

In some examples, the method further comprises receiving, at the processing device, a charge complete signal from the charger when charging of the batter is complete; and in response to receiving the charge complete signal, displaying, by the processing device, a charge complete notification via the user interface of the user device, the charge complete notification indicating that charging of the battery is complete. Optionally, displaying the estimated state of charge includes determining whether the estimated state of charge is below a state of charge threshold, and displaying the estimated state of charge when the estimated state of charge is below the state of charge threshold. When the estimated state of charge is below the state of charge threshold, the method may further comprise transmitting, by the processing device, a low state of charge sound signal to a hearing aid device corresponding to the battery. The hearing aid device may be configured to audibly alert a user wearing the hearing aid device in response to receiving the low state of charge sound signal.

In some implementations, the method further comprises storing, by the processing device, a notification time set by a user of the user device in a storage device. The notification time may indicate a time to charge the battery. When the charger is not charging the battery at the notification time, the method may further comprise displaying, by the processing device, a reminder notification via the user interface of the user device; and/or transmitting, by the processing device, a charging reminder sound signal to a hearing aid device corresponding to the battery. The hearing aid device may be configured to audibly remind a user wearing the hearing aid device to charge the battery in response to receiving the charging reminder sound signal.

In some examples, the battery corresponds to a hearing aid device that operates in a hearing aid mode and a wireless streaming mode, whereby the user device streams sound signals to the hearing aid device during the wireless streaming mode. In this example, the method may further include determining the estimated state of charge of the battery by: (i) determining a first amount of time that the hearing aid device operates in the wireless streaming mode during the period after the most recent charging session; (ii) determining an estimated wireless drain indicating an estimated amount of charge drained from the battery during operation in the wireless mode; (iii) determining a second amount of time that the hearing aid device operates in in the hearing aid mode; (iv) determining an estimated hearing aid drain indicating an estimated amount of charge drained from the battery during operation in the hearing aid mode; and (v) determining the estimated state of charge based on the charge capacity, the estimated wireless drain, and the estimated hearing aid drain.

The details of one or more implementations of the disclosure are set forth in the accompanying drawings and the description below. Other aspects, features, and advantages will be apparent from the description and drawings, and from the claims.

DESCRIPTION OF DRAWINGS

The following figures are provided by way of example and are note intended to limit the scope of the claimed invention.

FIG. 1A is a schematic view of an example environment for a battery charger communication system.
FIG. 1B is a schematic view of an example charging unit.
FIG. 2A is a schematic view of an example environment for a battery charger communication system.
FIG. 2B is a schematic view of an example charging unit.
FIG. 3A is a schematic view of an example charging server.
FIG. 3B is a flowchart of an example method for providing an estimated state of charge of a battery to a user device.
FIGS. 4A and 4B are schematic views of example user devices displaying an estimated state of charge of a remotely located battery.
FIG. 5A is schematic view of an example user device displaying a reminder notification and transmitting a charging reminder sound signal to a hearing aid device.
FIG. 5B is a schematic view of an example user device displaying a warning notification and transmitting a low state of charge sound signal to a hearing aid device.
FIGS. 6A-6C are schematic views of example screens displayed on a user device executing an application.

Like reference symbols in the various drawings indicate like elements.

DETAILED DESCRIPTION

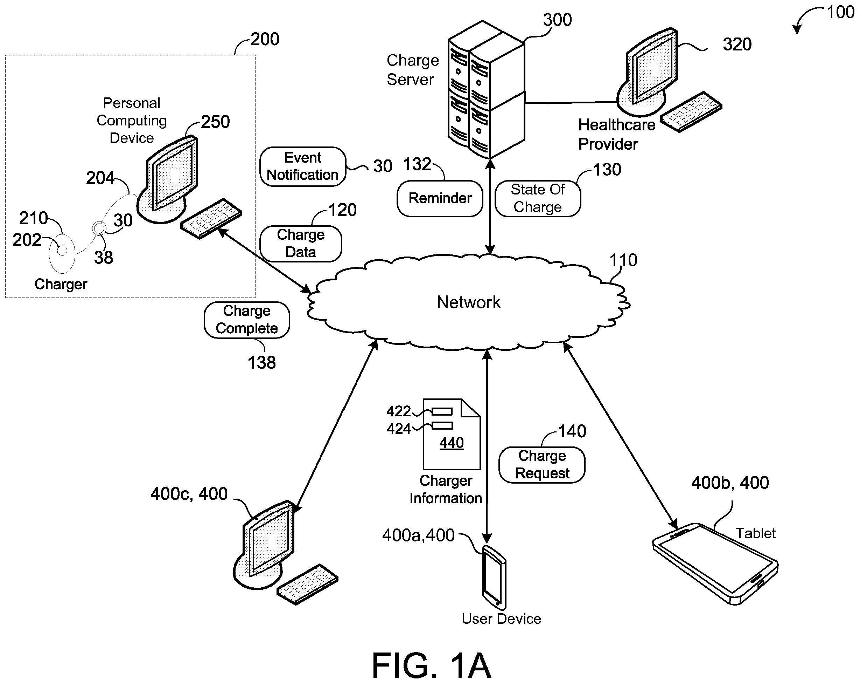

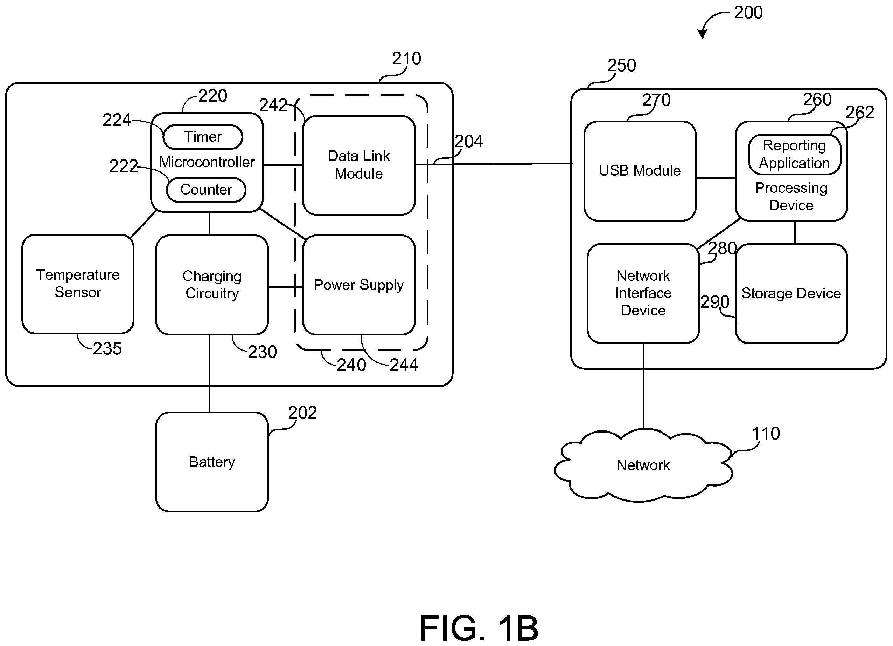

In some implementations, referring to FIGS. 1A and 1B an example battery charger communication system 100 includes a charging unit 200 that charges a rechargeable battery 202. The charging unit 200 can include a charger 210 that is connected to a personal computing device 250 (desktop or laptop) via, for example, a USB connection 204 or any other suitable data/power transfer means. In some implementations, the computing device 250 is connected to a network 110 and communicates charge data 120 to a charge server 300. As used herein a network can include one or more of the Internet, an intranet, and/or a personal network.

In some implementations, the computing device 250 transmits the charge data 120 after each charging session (e.g., after the battery 202 is removed from the charger 210 or after charging is complete but the battery 202 still remains docked with the charger 210). In some implementations, the charging unit 200 is connected to the network 110 via a network interface device. In these implementations, the charging unit 200 transmits the charge data 120 to the charge server 300 over the network 110 and without using the computing device 250 as an intermediary.

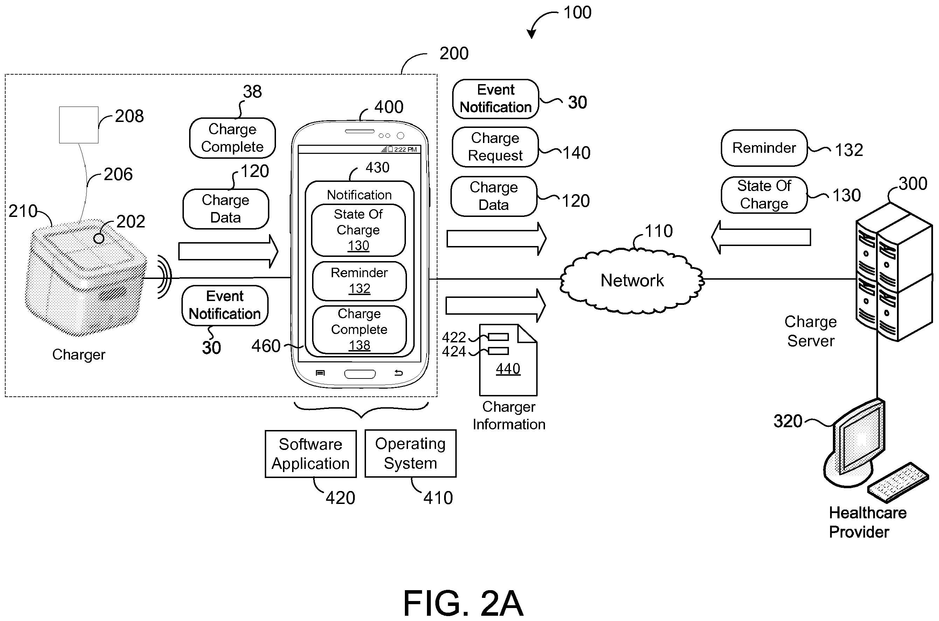

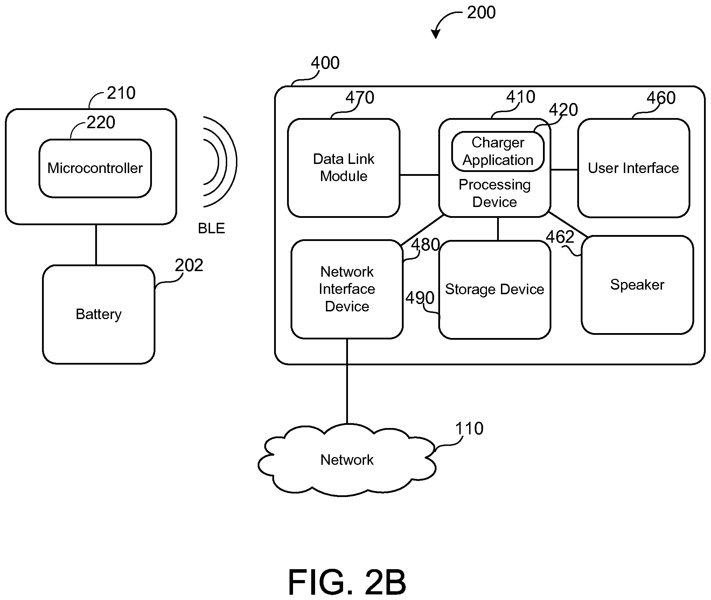

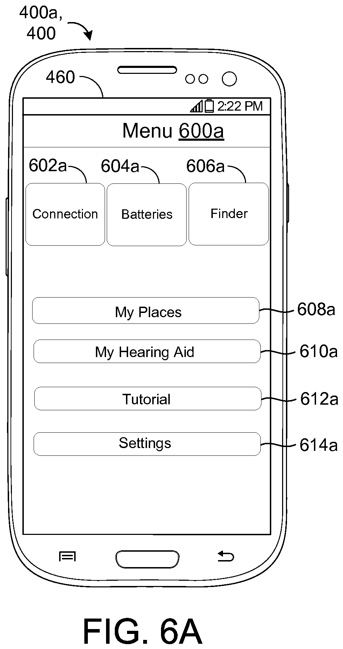

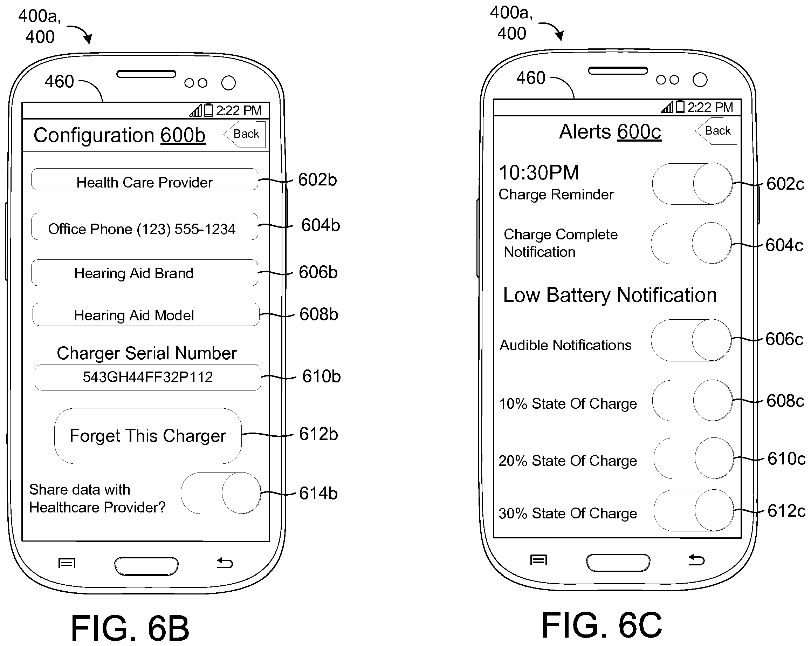

The charge server 300 utilizes the charge data 120 to estimate the state of charge 130 of the battery 202. The charge server 300 communicates the estimated state of charge 130 to a user device 400 associated with a user of the battery 202. While the user device 400 is depicted as a smartphone 400a, the user device 400 can be any suitable device 400 that can connect to a network 110 and has a user interface 460 (FIG. 2A), such as a touchscreen or a display device. Non limiting examples of user devices 400 include mobile computing devices (e.g., smartphones 400a and tablets 400b), stationary computing devices 400c (e.g., desktop computers, and wearable computers (e.g., smart watches and smart glasses). The user device 400 displays the estimated state of charge 130 of the battery 202 as a visual notification via the user interface 460 and/or as an audible notification via a speaker 462 (FIG. 2B) of the user device (400). In some implementations, the charge server 300 "pushes" the estimated state of charge 130 of the battery 202 to the user device 400 when the estimated state of charge 130 is less than a state of charge threshold (e.g., < 20 %). As described in greater detail with reference to FIG. 6C, a user 10 may set the state of charge threshold at which the charge server 300 will "push" the estimated state of charge 130 of the battery 202. Additionally or alternatively, the user device 400 can send a state of charge request 140 ("SOC request") to the charge server 300, the SOC request 140 requesting the estimated state of charge 130 of the battery 202. The charging server 300 can connect to multiple charging units 200 and multiple user devices 400. Additionally or alternatively, the user device 400 can be configured to display reminder notifications 132 to the user at preset times to remind the user to charge the battery 202. For instance, as shown in FIG. 6C, the user 10 may set the notification time to 10:30 P.M. to remind the user 10 to charge the battery 202 before going to sleep. In some examples, the server 300 pushes the reminder notification 132 to the user device 400 at the set notification time, causing the user device 400 to display the reminder notification 132 on the user interface 460.

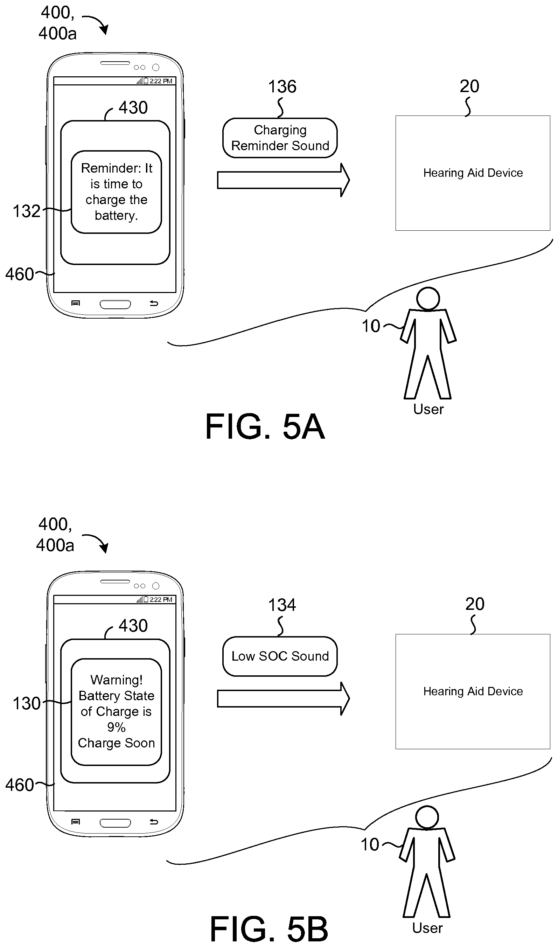

The battery charger communication system 100 allows a user to know the estimated state of charge 130 of the battery 202 of a device 20 (not shown) that does not include a user interface. For example, the battery 202 may power a hearing aid device 20 (FIGS 5A and 5B) not having the capabilities of visually reporting a state of charge 130 of the battery 202 and unlikely having the processing capabilities to determine the state of charge 130 of the battery 202. Thus, the battery charger communication system 100 allows an estimated state of charge 130 to be sent to a user device 400 of the user that is associated with the battery 202, thereby letting the user know when he or she needs to charge the battery 202 or alter use of the hearing aid device 20 to preserve the battery capacity. Additionally, the battery charger communication system 100 may send an estimated state of charge 130 to the user device 400 during a charging session of the battery 202 by the charger 210.

FIG. 1B is an example of the charging unit 200 of the battery charger communication system 100 of FIG. 1A. In this implementation, the charging unit 200 includes the charger 210 and the computing device 250. The example charging unit 200 shows the charger 210 charging the battery 202 using power received from the computing device 250 via a USB connection 204. Additionally or alternatively, the charger 210 may charge the battery 202 using power received from any suitable power source, such as an alternating current power source 208 (FIG. 2A) via a power connection 206 (FIG. 2A).

The battery 202 can be any suitable battery 202. For instance, the battery 202 can be rechargeable silver-zinc, nickel metal-hydride, lithium-ion based chemistries. In some implementations, the battery 202 is a battery that is used in a hearing aid. The battery 202 can be for any suitable device that receives rechargeable batteries and does not have a user interface, including but not limited to, Bluetooth headset, cochlear implant, drug delivery device, watch, other body worn medical or fitness devices.

The example charger 210 includes a microcontroller 220, charging circuitry 230, a temperature sensor 235, a data link 242, and a power supply 244. In some implementations, the data link 242 and the power supply 244 are combined in a USB module 240 that receives power and data from a remote device via a USB link 204. The charger 210 may include other components not shown. The computing device 250 can include a processing device 260 executing a reporting application 262, a USB module 270, a network interface device 280, and a storage device 290. The computing device 250 can include additional components not shown.

In operation, a user can connect the battery 202 to the charger 210 via an interface that connects the battery 202 to the charging circuit 230. Upon connecting the battery 202 to the charging circuitry 230, the microcontroller 220 begins to execute a charging session. The microcontroller 220 can maintain a device usage timer 224 and a charge capacity counter 222. The device usage timer 224 counts an amount of time that the battery 202 has been off the charger 210. The value of the device usage timer 224 can be used to approximate an amount of time that the battery 202 (or batteries) was in use ("device usage-time").

The charge capacity counter 222 counts the amount of charge capacity (ampere-hours or milli-ampere hours) that is delivered to the battery 202 during a charging session ("charge capacity"). When the battery 202 is seated into the charger 210, the microcontroller 220 records the device usage-time based on the value of the device usage timer 224, thereby recording an approximate amount of time that the battery 202 was in use. The microcontroller 220 also resets and starts the charge capacity counter 222. In particular, the charge capacity counter 222 monitors the amount of charge delivered to the battery 202 during the charging session. The charge capacity counter 222 can include circuitry that monitors the charge delivered by the power supply 244. In some implementations, the microcontroller 220 is further configured to estimate an amount of time that is needed to fully charge the battery 202. The microcontroller 220 can estimate the amount of time based on the charge capacity of the battery 202, the amount of charge delivered to the battery 202 during the current charging session, the rate at which charge is being delivered, and the state of charge of the battery when the battery 202 was docked with the charger 210.

In some implementations, the microcontroller 220 obtains an ambient temperature reading from the temperature sensor 235 at the start of the charge. The microcontroller 220 can also communicate an event notification 30 to the computing device 250 thereby indicating that the charger 230 has started charging the battery 202. The microcontroller 220 can be further programmed to send a charge complete signal 38 to the computing device 250 indicating that the charge is complete. Upon receiving signal 38, the computing device 250 can forward a charge complete notification 138 to the user device 400 via the charge server 300 or directly to the user device 400 without using the charge server 300. The microcontroller 220 can execute any suitable charging algorithm to control the current being delivered from the power supply 244 to the battery 202 via the charging circuit 230.

When the battery 202 is removed from the charger 210 (e.g., when the charge is interrupted or when charging is complete), the microcontroller 220 stops the charge capacity counter 222 and records the charge capacity based on the amount of charge capacity charged in the battery 202. The microcontroller 220 further resets and restarts the device usage timer 224. The microcontroller 220 can also record the current at the end of the charge (the "end current"). Furthermore, in some implementations, the microcontroller 220 obtains an ambient temperature reading at the time that the battery 202 was unseated from the charger 210. The microcontroller 220 can communicate the recorded device usage-time, the end current, and charge capacity of the battery after the charging session to the computing device 250 via the data link 242, as well as a signal (e.g., signal 38) that the battery 202 has been removed from the charger 210. Furthermore, in some implementations, the ambient temperatures taken at the beginning and at the end of the charge are communicated to the computing device 250 as well.

The reporting application 262 receives the various parameters from the charger 210 and reports event notifications 30 and charge data 120 to the charge server 300. Event notifications 30 can include a notification that the battery 202 is seated in, or docked with, the charger 210 and notification that the battery 202 is unseated, or undocked from, from the charger 210. Each time the battery 202 is seated or unseated, the reporting application 262 sends an event notification 30 to the server 300. Each time the battery 202 is unseated, the reporting application 262 also transmits the charge data 120 to the charge server 300. The charge data 120 can include, but is not limited to, an identifier 424 of the charger 210 (a "charger ID"), the most recent charge capacity, the most recent device usage-time (i.e., how long the battery 202 was off the charger 210 prior to the most recent charging session), an amount of charge that was delivered to the battery 202 during the most recent charging session, the end current, and the ambient temperatures at the beginning and end of the charging session. Referring to FIG. 1A, the user device 400 may provide charger information 440 to the charge server 300 to link the user device 400 (and user thereof) with the charger 210. The charger information 440 may include an identifier 422 of the user device 400 (a "user device ID") and the charger ID 424. Accordingly, the charge server 300 can identify the user device 400 associated with the charger 210 using the charger ID 424 included in the charge data 120. Likewise, the charge server 300 can identify the estimated state of charge 130 of the battery 202 associated with the charger 210 using the user device ID 422 included in a charge request 140 received from the user device 400 requesting the state of charge 130.

In some implementations, the reporting application 262 also determines an amount of charge of the battery 202. The reporting application 262 can average the calculation of the devise usage time divided by the charge capacity over the previous N (e.g., ten) cycles. This calculation provides an average discharge current for the battery 202. The reporting application 262 can communicate with the server 300 to determine what time the battery 202 was removed from the charger 210 and then use that time to calculate how much capacity has been drained from the battery 202. The estimated state of charge 130 of the battery 202 can also be communicated to the server 300 in the charge data 120.

The reporting application 262 can include additional information in the charge data 120. For instance, the reporting application 262 can determine whether the most recent charge ended before the charge was complete. If so, the reporting module 262 can set a flag that the charging session was incomplete. Other pertinent information can be reported in the charging data 120 as well.

The reporting application 262 can be further configured to report charge complete notifications 138 to the user device 400. When a charging unit 200 transmits a charge complete signal 38 to the computing device 250, the charging unit 200 can identify a user device 400 that corresponds to the charging unit 200. The reporting application 262 can then provide a charge complete notification 138 to the user device 400. In response to the charge complete notification 138, the user device 400 can provide an audio and/or visual notification 138 to the user, thereby indicating that the charging unit 210 has completed charging the battery 202. The visual notification 138 may be displayed upon the user interface 460 while the audio notification 138 may sound through the speaker 462.

In some implementations, referring to FIGS. 2A and 2B, the charging unit 200 of the system 100 includes the user device 400 in wireless communication with the charger 210. The charger 210 and the user device 400 may include data link modules 242, 470, respectively, permitting wireless communication over the network 110, such as Bluetooth Low Energy (BLE) or other communication, between the charger 210 and the user device 400. Alternatively, the user device 400 and the charger 210 may communicate via a USB connection 204. The user device 400 may use a variety of different operating systems 410. In examples where the user device 400 is a mobile device 400a, 400b, the user device 400 may run an operating system including IOS® developed by Apple Inc., ANDROID® developed by Google Inc., or WINDOWS PHONE® developed by Microsoft Corporation. In some examples a user device may run an operating system including, but not limited to MICROSOFT WINDOWS® by Microsoft Corporation, MAC OS® by Apple, Inc., or Linux. The operating system 410 may execute one or more software applications 420. A software application 420 may refer to computer software that, when executed by a computing device, causes the computing device to perform a task. In some examples, the software application 420 may be referred to as an "application", an "app", or a "program". Applications 420 can be executed on a variety of different user devices 400. In some examples, the user may download and install applications 420 on the user device 400.

The charger 210 may charge the battery 202 using power received from any suitable power source, such as an alternating current power source 208 (e.g., power wall outlet) via a power connection 206. The charger 210 may, however, include one or more USB ports for connecting to a personal computing device and/or the user device 400

In some implementations, the user device 400 executes a charger application 420 that communicates with the charger 210 and/or the charge server 300. Using the charger application 420, the user may provide the charger information 440 to register the charger 210 and the user device 400 with the charge server 300. The charger information 440 may be input to the user device 400 by a qualified healthcare provider, such as an audiologist, during an initial configuration process. FIG. 6B provides an example screen 600b displayed upon the user interface 460 of the user device 400 for inputting charger information 440 using the charger application 420.

In some scenarios, the charger application 420 serves as an intermediary between the charger 210 and the charge server 300, where the charger application 420 receives charge data 120 from the charger 210 and transmits the charge data 120 to the charge server 300. In this scenario, the user device 400 executing the charger application 420 replaces the personal computing device 250 described above with reference to FIGS. 1A and 1B. Accordingly, the charger application 420 may execute all of the operations of the reporting application 262. The charge server 300 may transmit the estimated state of charge 130 through the network 110 to the user device 400 when the estimated state of charge 130 is below the state of charge threshold (e.g., < 20%) and/or in response to the charge request 140 from the user device.

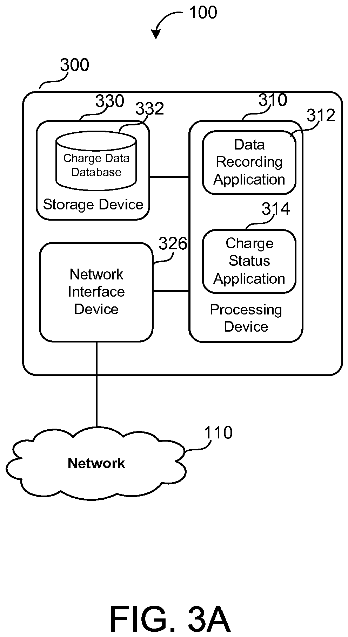

The user device 400 may receive the charge data 120 and charge complete signal 38 from the charger 210 and display (or audibly sound) the charge complete notification 138 based on the received signal 38. A network interface device 480 of the user device 400 may provide the charge data 120 and the charger information 440 to the charge server 300 via the network 110. The charge data 120, including historical charge data 120, corresponding to the charger 210 (and associated battery 202 and user device 400), may be accessed by an authorized healthcare provider 320 via the charge server 300. The user device 400 may also transmit a charge request 140 to the charge server 300 and receive an estimated state of charge 130 in response thereto; however, the charger application 420 executing on the user device 400 may determine the estimated state of charge 130 without using the charge server 300. The charger application 420 may execute some or all of the operations executed by a data recording application 312 and a charge status application 314 of the charge server 300, as described in further detail below in FIG. 3A. For instance, the charger application 420 may retrieve charge data 120 from a storage device 290 and determine an estimated state of charge 130 of the battery 202. In this scenario, the user device 400 may receive the charge data 120 from the charger 210 and store the charge data in a storage device 290.

The charger application 420 receives various parameters from the charger 210 and/or the charge server 300 and displays one or more notifications 430 upon the user interface 460 for the user to view. For example, the charger application 420 may display the estimated state of charge, reminder, and/or charge complete notifications 130, 132, 138, respectively, upon the user interface 460. Additionally or alternatively, the charger application 420 may provide the one or more notifications 430 audibly through the speaker 462 of the user device 400.

FIG. 3A illustrates an example of the charge server 300. The charge server 300 can include a processing device 310, a network interface 326, and a storage device 330 that stores a charge data database 332. The charge server 300 may be implemented as a single stand-alone device or across multiple devices. The charge server 300 may act independently or as a component of a larger system.

The server 300 communicates with a plurality of charging units 200 and a plurality of user devices 400 via the network 110. When a user purchases a new charger 210, the charger 210 may be labeled with a charger ID 424. The user can register the charger 210 and a user device 400 by accessing the server 300 using the charger application 420 executing on the user device 400. The user can enter the charger ID 424 into the user device 400. The user device 400 communicates the charging information 440 that includes the charger ID 424 and a user device ID 422 to the server 300 and the server 300 associates the charger ID 424 of the charger 210 to the device ID 422 of the user device 400. In this way, the server 300 links a charger 210 to a user device 400 of the user.

The processing device 310 can execute a data recording application 312 and a charge status application 314. The data recording application 312 can register new charger 210/user device 400 combinations in the charge data database 332. Furthermore, each time charge data 120 is received from a charging unit 200, the data recording application 312 records the charge data 120 in the charge data database 332. The charge data database 332 can store charge records that indicate historical charge data 120 for each registered charger 210. When the data recording application 312 receives charge data 120 from a charging unit 200, the data recording application 312 can identify the charger 210 that recorded the charge data 120 based on the contents of the charge data 120. The data recording application 312 can create a new record that identifies the charger 210 corresponding to the charger ID 424 and includes the received charge data 120, including the charge capacity, the device usage-time, and the amount of charge delivered to the battery 202 at the end of the charge. Furthermore, for each record, the data recording application 312 can apply a timestamp to the record. The timestamp can indicate a time at which the battery 202 was removed from the charger 210 after the charging session corresponding to the record. The charge status application 314 can generate the timestamp when it receives an event notification 30 from the charging unit 200 indicating that the battery 202 has been removed from the charger 210. In some scenarios, the timestamp may indicate a time when a charging session was interrupted before charging was complete. In some implementations, the recording application 312 may be further configured to include a second timestamp that identifies a time at which the charging session was completed. In these implementations, the second timestamp may differ from the time when the battery 202 was removed from the charger 210. For instance, if the battery 202 remains on the charger 210 for a period after the battery 202 is fully charged, the timestamp that indicates when the battery 202 was removed from the charger 210 will have a later time than the second timestamp. In some implementations, the recording application 312 generates the second timestamp upon receiving a charge complete notification. Table I illustrates an example of a set of charge records for a particular charger 210.

TABLE I

| Cycle | Start Temp (C°) | End Temp (C°) | Charge Time (h) | Device Usage Time (h) | Charge Capacity (mAh) | Charge interrupted | Start of Device Usage Time |
|-------|-----------------|---------------|-----------------|-----------------------|-----------------------|--------------------|----------------------------|
| 1 | 25.0 | 25.0 | 4.5 | 14.4 | 18.7 | 0 | 08:42 |
| 2 | 27.0 | 26.0 | 4.7 | 15.2 | 19.7 | 0 | 09:02 |
| 3 | 28.0 | 29.0 | 4.5 | 14.4 | 19.4 | 0 | 08:37 |
| 4 | 25.0 | 27.0 | 4.2 | 13.2 | 20.2 | 0 | 09:47 |
| 5 | 27.0 | 30.0 | 4.9 | 14.0 | 14.0 | 0 | 07:48 |
| 6 | 31.0 | 31.0 | 3.0 | 15.8 | 28.2 | 1 | 08:42 |
| 7 | 29.0 | 30.0 | 4.5 | 13.4 | 19.6 | 0 | 07:58 |
| 8 | 33.0 | 31.0 | 4.1 | 15.8 | 20.5 | 0 | 08:02 |
| 9 | 32.0 | 28.0 | 4.8 | 13.9 | 20.3 | 0 | 09:02 |
| 10 | 30.0 | 27.0 | 4.2 | 15.0 | 19.4 | 0 | 07:37 |

Once a user device 400 is associated with a charger 210, the charge status application 314 can begin reporting estimated states of charge 130 to the user device 400. As previously indicated, the charge status application 314 can report an estimated state of charge 130 of the battery 202 to the user device 400 when the estimated state of charge 130 of the battery 202 dips below a state of charge threshold value (e.g., < 10%). Additionally or alternatively, the user device 400 can request 140 an estimated state of charge 130 from the server 300. In such a scenario, the charge status application 314 calculates the estimated state of charge 130 in response to the request 140 and transmits the estimated state of charge 130 to the user device 400. In other implementations, the charge application 420 executing on the user device 400 calculates the estimated state of charge 130.

In some implementations, the charge status application 314 can be further configured to push reminder notifications 132 to the user device 400 to remind a user to charge the battery 202. In these implementations, the user may set a reminder time at which the notification is to be sent (e.g., 10:30 PM). If the charge status application 314 does not receive an event notification 30 indicating that the battery 202 is charging before the reminder time, the charge status application 314 can send the reminder notification 132 to the user device 400. In response to receiving the reminder notification 132, the user device 400 can provide an audio via the speaker 462 and/or visual notification to the user via the user interface 460 of the user device 400. In some implementations, the charger application 420 executing on the user device 400 notifies the user to charge the battery 202 based on the reminder time set by the user and stored within the storage device 490 of the user device 400. If the charging application 420 does not receive the event notification 30 indicating that the battery 202 is charging before the reminder time, the charging application 420 generates and provides the audio and/or visual reminder notification 132 to the user via the speaker 462 and/or the user interface 460. In some examples (e.g., FIGS. 5A and 5B), the battery 202 powers a hearing aid device 20 that can operate in a "wireless mode", whereby the user device 400 (e.g., smartphone 400a) is configured to transmit sounds to the hearing aid apparatus over a wireless link (e.g., Bluetooth Low Energy). For instance, the estimated state of charge notification 130 and/or the reminder notification 132 may be wirelessly provided from the user device 400 to the hearing aid device 20 to audibly notify the user associated with the hearing aid device 20.

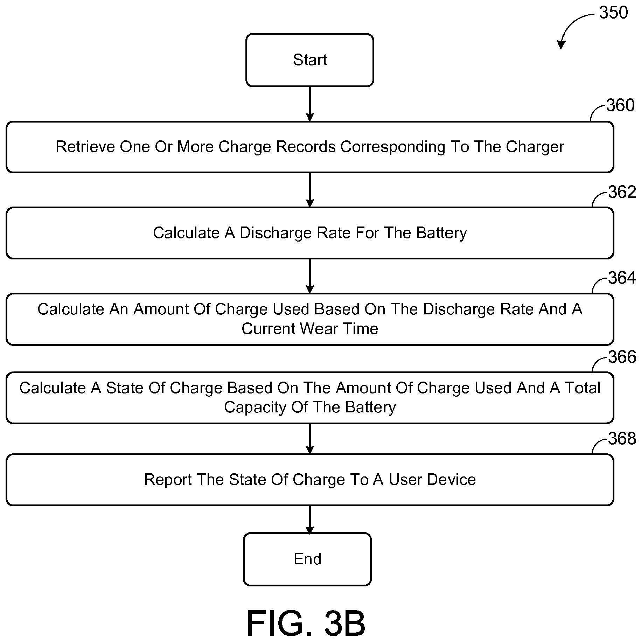

FIG. 3B illustrates an example method 350 for determining an estimated state of charge 130 of a battery 202. For purposes of explanation, the method 350 is described in relation to the charge status application 314, which is executed by the processing device 310. However, the charger application 420 executing on the user device 400 may similarly execute some or all of the operations of the method 350 instead of, or in combination with, the charge status application 314. The method 350 can be executed periodically (e.g., every few hours) or in response to a request from a user device 400.

At operation 360, the charge status application 314 retrieves one or more charge records from the charge data database 332. The charge status application 314 retrieves charge records for the same charger 210. In some implementations, the charge status application 314 retrieves the charge records using the charger ID 424 of the charger 210. The charge status application 314 retrieves the most recent charge records and the number of charge records that are retrieved can be equal to the number of charging cycles that the charge status application 314 uses to determine the discharge rate of the battery 202. In other implementations, the charger application 420 retrieves the charge records for the charger 210 from the storage device 490.

At operation 362, the charge status application 314 (or the charger application 420 executing on the user device 400) calculates an average discharge rate for the battery 202. The average discharge rate can be calculated by determining a discharge rate of the battery 202 for each of the previous N discharge cycles, where N is an integer greater than or equal to one (e.g., ten). For each of the N discharge cycles, the charge status application 314 can calculate the discharge rate according to equation (1), as follows.

$$Discharge\ Rate_i = \frac{ChargeCapacity_i}{Device\ Usage\ TIme_i} \qquad (1)$$

where the ChargeCapacity$_i$ and DeviceUsageTime$_i$, respectively represent a charge capacity value and a device usage time from the ith charge record of the N selected charge records. The charge status application 314 can then calculate an average discharge rate using the N previous discharge rates.

At operation 364, the charge status application 314 calculates an estimated amount of charge used from the battery 202 since the battery 202 was removed from the charger 210. The charge status application 314 utilizes the timestamp associated with the most recent record and the current time to estimate an amount of time that the battery 202 has been in use since the most recent charging session ("current device usage time"). The charge status application 314 can calculate the estimated amount of discharge used from the battery 202 according to equation (2), as follows.

$$Amount\ Of\ Discharge = Discharge\ Rate * Current\ Device\ Usage\ Time \qquad (2)$$

At operation 366, the charge status application 314 calculates an estimated state of charge based on the amount of charge value and the fully charged capacity of the battery. The fully charged capacity of the battery 202 can be learned during the use of the battery or can be obtained from the manufacturer of the battery 202. The charge status application 314 can calculate the estimated state of charge of the battery according to equation (3), as follows.

$$Estimated\ State\ of\ Charge = \frac{Fully\ Charged\ Capacity - Amount\ of\ Discharge}{Fully\ Charged\ Capacity} \quad (3)$$

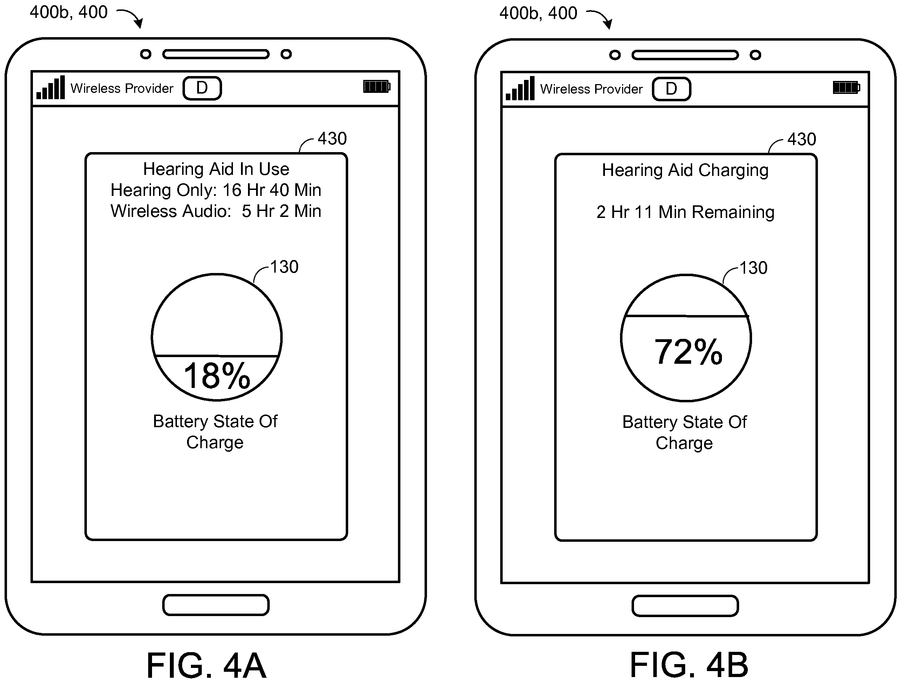

At operation 368, the charge status application 314 can report the estimated state of charge 130 to the user device 400 associated with the charger 210. In some implementations, the charge status application 314 only provides the estimated state of charge 130 when the estimated state of charge 130 is below a threshold (e.g., less than 20%). Additionally or alternatively, the charge status application 314 can transmit the estimated state of charge 130 in response to a request for the same. Upon receiving the estimated state of charge 130, the user device 400 can provide an audible alert and/or display the estimated state of charge 130 as a notification 430 to the user, as shown at FIG. 4A. The estimated state of charge 130 may include text and symbols (e.g., a meter) indicating the estimated state of charge 130. While shown in the middle of the screen, the state of charge 130 can be displayed by the user device 400 in any suitable manner. In some examples, when the battery 202 is associated with a hearing aid device 20, the user device 400 may wirelessly transmit a sound the hearing aid device 20 that corresponds to the estimated state of charge 130.

The method 350 of FIG. 3B is provided for example only and not intended to limit the scope of the disclosure. Furthermore, the equations provided above are provided for example only and other equations may be used to calculate the estimated state of charge 130.

The charger communication system 100 can be implemented according to a number of alternative implementations without departing from the scope of the disclosure. For example, in some implementations, the charger 210 includes a network interface device, such that the charger 210 can communicate with the server 300 directly. In these implementations, the reporting application 262 can be executed by the microcontroller 220 of the charger 210 (or an additional processor).

In some implementations, the user device 400 is configured to determine the estimated state of charge of the battery 202. In these implementations, the user device 400 can receive the charge data 120 directly from the charging unit 200 or from the server 300. The user device 400 can further maintain historical charge data 120 (e.g., the previous N charge records) for the charger 210 on the storage device (e.g., flash memory) of the device 400. The user device 400 can determine the estimated state of charge 130 based on the historical data and the most recently received charge data 120. In these implementations, the user device 400 can display the estimated state of charge 130 at the request of the user, at predetermined time intervals (e.g., every hour), and/or when the estimated state of charge 130 dips below a predetermined state of charge threshold (e.g., < 20%).

In some implementations, the charging unit 200 maintains the historical charge data 120 and calculates the estimated state of charge 130. In these implementations, the charging unit 200 calculates the estimated state of charge 130 in the manner described above. The charging unit 200 can then communicate the estimated state of charge 130 to the server 300 or the user device 400 directly.

In some implementations, the battery 202 is used in a hearing aid device 20. In some hearing aid devices 20, the devices 20 can operate in a "hearing aid mode", whereby the hearing aid amplifies sounds received by its microphone. The device 20 can also be operated in a "wireless mode", whereby a user device 400 (e.g., smartphone) is configured to transmit sounds to the hearing aid device over a wireless link (e.g., Bluetooth Low Energy). The hearing aid device 20 will draw more power when operating in the later mode (i.e., "wireless mode"). In these implementations, the user device 400 is configured to monitor the amount of time it spends operating the hearing aid in the wireless mode to the charge server 300. In other words, the user device 400 monitors an amount of time that wireless streaming mode has been active during the current wear time, and displays the time to the user as shown in FIG. 4A. The amount of time spent in the "hearing aid mode" can be calculated based on the difference between the current wear time and the time spent in the "wireless mode". Thus, the discharge rate during a time period, $T_{Total}$, can be represented in the form of:

$$Discharge\ Rate = \frac{(T_{Wireless} * Wireless\ Discharge) + (T_{Hearing} * Hearing\ Discharge)}{T_{Total}} \quad (4)$$

Where *Discharge Rate* is the average discharge rate during the period of use, $T_{Wireless}$ is the amount of time spent in wireless mode, $T_{Hearing}$ is the amount of time spent in hearing aid mode, *Wireless Discharge* is a discharge rate attributed to wireless mode, and *Hearing Discharge* is a discharge rate attributed to hearing aid mode. In these implementations, if the user device 400 calculates the estimated state of charge 130 of the battery 202, the user device 400 can utilize a predetermined value for *Wireless Discharge* and/or *Hearing Discharge* to estimate the average discharge rate. In this way, the user device 400 may be able to more accurately calculate the values of *Wireless Discharge* and/or *Hearing Discharge.* The values of *Wireless Discharge* and/or *Hearing Discharge* can be determined heuristically during the continued use of the battery 202 (e.g., using the previous three or four previous use periods to determine the respective values).

In some implementations, the estimated state of charge and remaining charge time are determined while the charger 210 is charging the battery 202. In these examples, the charging data 120 may include the discharged state of charge and the amount of charge capacity of the battery 202, as counted by the capacity counter 222 during the charge session. The charge capacity is determined based on the charge current being delivered by the charger 210 in some examples, while in other examples when charge current is unobtainable, a default charge rate is used. Accordingly, the estimated state of charge 130 and a remaining charge time can be determined during the charging session and provided to the user device 400 for display as a notification 430 to the user, as shown in FIG. 4B. When the amount of time the battery 202 is docked or seated with the charger 210 exceeds a charging time threshold (e.g., 6 hours), the user device 400 may be configured to display a 100% state of charge.

Referring to FIGS. 5A and 5B, the user device 400 may be configured to wirelessly communicate (e.g., via Bluetooth Low Energy) with a hearing aid device 20 associated with the one or more batteries 202. Additionally, a user 10 is associated with the one or more batteries 202, the user device 400 and the hearing aid device 20.

FIG. 5A provides an example mobile user device 400a displaying a notification reminder 132 upon the user interface 460 to inform the user 10 that it is time to charge the battery 202 (or batteries). The user 10, via the charger application 420, may set a notification time to remind the user to charge battery 202. When the battery 202 is not undergoing a charging session at the notification time (e.g., no event notification 38 received), the user device 400 may display the reminder notification 132. Additionally or alternatively, the user device 400 may transmit a charging reminder sound signal 136 to the hearing aid device 20 to audibly remind the user 10 wearing the hearing aid device 20 to charge the battery 202.

FIG. 5B provides an example mobile user device 400a displaying a state of charge notification 130 upon the user interface 460 to provide the user 10 the estimated state of charge 130. In the example shown, the estimated state of charge notification 130 may be displayed when the estimated state of charge 130 is below a threshold state of charge value (e.g., 10%); however, the estimated state of charge notification 130 may be displayed in response to a charge request 140 from the user 10. Additionally or alternatively, the user device 400 may transmit (e.g., wirelessly stream) a low state of charge sound ("Low SOC Sound") signal 134 to the hearing aid device 20 to audibly alert the user 10 wearing the hearing aid device 20 that the state of charge of the battery 202 is low so that the user 10 can charge the battery 202.

FIGS. 6A-6C provide example screens 600a-c displaying on a user interface 460 of a mobile user device 400a executing a charger application 420. FIG. 6A shows a Menu screen 600a displaying graphical elements 602a-614a (e.g., buttons) that advance the user interface 460 to a corresponding screen when selected via a user input. The user input may include touching or tapping the corresponding button 602a-614a, or the user input may be a gesture or speech command. Upon selecting the Connection button 602a, the user may view a connection screen to view a wireless connection between the user device 400 and the charger 210 and/or the hearing aid device 20. Accordingly, the user may pair the user device 400 with the charger 210 and/or the hearing aid device 20. Upon selecting the Batteries button 604a, the user may view a batteries screen to view charge data 120 related to the batteries 202 such as the estimated state of charge 130. In some examples, selecting the Batteries button 604a results in the charger application 420 generating a charge request 140. Upon selecting the Finder button 606a, the user interface 460 may display a screen or search field enabling the user to input a query. The My Places button 608b, when selected, may advance to one or more screens configured by the user that the user frequently accesses. The My Hearing Aid button 610a may advance to a screen displaying pertinent information related to the hearing aid device 20, such as a model number and technical specifications. The user may select the Tutorial button 612a to view a tutorial for navigating the charger application 420 and/or instructions for operating the charger 210. Upon selecting the Settings button 614a, the user interface 460 may advance to one or more screens that enable the user to adjust one or more settings relating to the charger application 420, receiving alerts, receiving notifications, sharing information with a healthcare provider 320, etc.

FIG. 6B shows a Configuration screen 600b displaying graphical elements 602b-614b (e.g., text fields, buttons, selectors) that allow a user or healthcare provider 320 to input information for the user to access or the healthcare provider to access through the charge server 300. The healthcare provider 320 for the user may initially configure the charger application 420 for the user via the Configuration screen 600b. For instance, the name of the user's healthcare provider, the phone number of the health care provider, the hearing aid brand, the hearing aid model and the charger serial number may be input to text fields 602b, 604b, 606b, 608b, 610b, respectively. By selecting the Forget This Charger button 612b, the charger 210 currently associated with the user device 400 may be removed. Selector 614b allows the user to select whether or not he or she desires to share data with the healthcare provider 320.

FIG. 6C shows an Alerts screen 600c displaying graphical elements 602c-612c (e.g., selectors) that allow a user to select how and/or when alerts and/or notifications are provided. Selector 602c allows the user to turn on or off a charge reminder at a set reminder time (e.g., 10:30pm). The user, via selector 602c, may select to receive the charge complete notification 138. Additionally, the user may select how state of charge notifications 130 are provided to the user. Selector 606c allows the user to select to receive audible notifications or just visual notifications. The user may select to receive state of charge notifications 130 when the estimated state of charge is less than 10%, 20% and/or 30% via selectors 608c, 610c, 612c, respectively.

Referring to FIGS. 1A and 2A, the user's healthcare provider 320 may be authorized to access data (e.g., charge data 120) corresponding to the user via the charge server 300. The data may include information relating to, but not limited to, the historical charge data 120, battery type, battery condition, minimum and maximum discharge currents, wireless mode discharge currents, hearing aid type, wear use of the hearing aid device 20, user device, and/or settings of the charging application 420. The healthcare provider 320 may analyze information extracted from the data to determine the user/patient is not wearing is hearing aid device based on short wear times or forgetting to charge the batteries based on long wear times. Charge data 120 indicating charging interruptions may allow the healthcare provider to determine that the user is not fully charging the battery 202, and when charge data 120 is missing, a configuration of the wireless connection or the charger 210 being unpowered can be determined. Additionally, the hearing aid professional may determine faulty or expired hearing aid devices when the charge data 120 indicates high discharge capacities and/or the use behavior such as the volume of the hearing aid device 10 being increased.

Various implementations of the systems and techniques described here can be realized in digital electronic and/or optical circuitry, integrated circuitry, specially designed ASICs (application specific integrated circuits), computer hardware, firmware, software, and/or combinations thereof. These various implementations can include implementation in one or more computer programs that are executable and/or interpretable on a programmable system including at least one programmable processor, which may be special or general purpose, coupled to receive data and instructions from, and to transmit data and instructions to, a storage system, at least one input device, and at least one output device.

These computer programs (also known as programs, software, software applications or code) include machine instructions for a programmable processor, and can be implemented in a high-level procedural and/or object-oriented programming language, and/or in assembly/machine language. As used herein, the terms "machine-readable medium" and "computer-readable medium" refer to any computer program product, non-transitory computer readable medium, apparatus and/or device (e.g., magnetic discs, optical disks, memory, Programmable Logic Devices (PLDs)) used to provide machine instructions and/or data to a programmable processor, including a machine-readable medium that receives machine instructions as a machine-readable signal. The term "machine-readable signal" refers to any signal used to provide machine instructions and/or data to a programmable processor.

Implementations of the subject matter and the functional operations described in this specification can be implemented in digital electronic circuitry, or in computer software, firmware, or hardware, including the structures disclosed in this specification and their structural equivalents, or in combinations of one or more of them. Moreover, subject matter described in this specification can be implemented as one or more computer program products, i.e., one or more modules of computer program instructions encoded on a computer readable medium for execution by, or to control the operation of, data processing apparatus. The computer readable medium can be a machine-readable storage device, a machine-readable storage substrate, a memory device, a composition of matter effecting a machine-readable propagated signal, or a combination of one or more of them. The terms "data processing apparatus", "computing device" and "computing processor" encompass all apparatus, devices, and machines for processing data, including by way of example a programmable processor, a computer, or multiple processors or computers. The apparatus can include, in addition to hardware, code that creates an execution environment for the computer program in question, e.g., code that constitutes processor firmware, a protocol stack, a database management system, an operating system, or a combination of one or more of them. A propagated signal is an artificially generated signal (e.g., a machine-generated electrical, optical, or electromagnetic signal) that is generated to encode information for transmission to suitable receiver apparatus.

A computer program (also known as an application, program, software, software application, script, or code) can be written in any form of programming language, including compiled or interpreted languages, and it can be deployed in any form, including as a stand-alone program or as a module, component, subroutine, or other unit suitable for use in a computing environment. A computer program does not necessarily correspond to a file in a file system. A program can be stored in a portion of a file that holds other programs or data (e.g., one or more scripts stored in a markup language document), in a single file dedicated to the program in question, or in multiple coordinated files (e.g., files that store one or more modules, sub programs, or portions of code). A computer program can be deployed to be executed on one computer or on multiple computers that are located at one site or distributed across multiple sites and interconnected by a communication network.

The processes and logic flows described in this specification can be performed by one or more programmable processors executing one or more computer programs to perform functions by operating on input data and generating output. The processes and logic flows can also be performed by, and apparatus can also be implemented as, special purpose logic circuitry, e.g., an FPGA (field programmable gate array) or an ASIC (application specific integrated circuit).

Processors suitable for the execution of a computer program include, by way of example, both general and special purpose microprocessors, and any one or more processors of any kind of digital computer. Generally, a processor will receive instructions and data from a read only memory or a random access memory or both. The essential elements of a computer are a processor for performing instructions and one or more memory devices for storing instructions and data. Generally, a computer will also include, or be operatively coupled to receive data from or transfer data to, or both, one or more mass storage devices for storing data, e.g., magnetic, magneto optical disks, or optical disks. However, a computer need not have such devices. Moreover, a computer can be embedded in another device, e.g., a mobile telephone, a personal digital assistant (PDA), a mobile audio player, a Global Positioning System (GPS) receiver, to name just a few. Computer readable media suitable for storing computer program instructions and data include all forms of non-volatile memory, media and memory devices, including by way of example semiconductor memory devices, e.g., EPROM, EEPROM, and flash memory devices; magnetic disks, e.g., internal hard disks or removable disks; magneto optical disks; and CD ROM and DVD-ROM disks. The processor and the memory can be supplemented by, or incorporated in, special purpose logic circuitry.

To provide for interaction with a user, one or more aspects of the disclosure can be implemented on a computer having a display device, e.g., a CRT (cathode ray tube), LCD (liquid crystal display) monitor, or touch screen for displaying information to the user and optionally a keyboard and a pointing device, e.g., a mouse or a trackball, by which the user can provide input to the computer. Other kinds of devices can be used to provide interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

One or more aspects of the disclosure can be implemented in a computing system that includes a backend component, e.g., as a data server, or that includes a middleware component, e.g., an application server, or that includes a frontend component, e.g., a client computer having a graphical user interface or a Web browser through which a user can interact with an implementation of the subject matter described in this specification, or any combination of one or more such backend, middleware, or frontend components. The components of the system can be interconnected by any form or medium of digital data communication, e.g., a communication network. Examples of communication networks include a local area network ("LAN") and a wide area network ("WAN"), an inter-network (e.g., the Internet), and peer-to-peer networks (e.g., ad hoc peer-to-peer networks).

The computing system can include clients and servers. A client and server are generally remote from each other and typically interact through a communication network. The relationship of client and server arises by virtue of computer programs running on the respective computers and having a client-server relationship to each other. In some implementations, a server transmits data (e.g., an HTML page) to a client device (e.g., for purposes of displaying data to and receiving user input from a user interacting with the client device). Data generated at the client device (e.g., a result of the user interaction) can be received from the client device at the server.

While this specification contains many specifics, these should not be construed as limitations on the scope of the disclosure or of what may be claimed, but rather as descriptions of features specific to particular implementations of the disclosure. Certain features that are described in this specification in the context of separate implementations can also be implemented in combination in a single implementation. Conversely, various features that are described in the context of a single implementation can also be implemented in multiple implementations separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multi-tasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

**Claims**

1. A method (350) comprising:

   receiving, at a processing device (310), charge data (120) from a charging unit (200) via a network (110), the charging unit (200) including a charger (210) and the charge data (120) including a charge capacity indicating an amount of charge delivered to a battery (202) during a most recent charging session and a device (20) usage time indicating an amount of time that the battery (202) was off the charger (210) during a period preceding the most recent charging session;

determining, by the processing device (310), an average discharge rate of the battery (202) based on previously received charge data (120) corresponding to the battery (202);

determining, by the processing device (310), an estimated state of charge (130) of the battery (202) based on the average discharge rate and a current device (20) usage time, the current device (20) usage time corresponding to a period after the most recent charging session; and

providing, by the processing device (310), the estimated state of charge (130) to a user device (400) for display.

2. The method (350) of claim 1, wherein the battery (202) is used in a device (20) that does not have a user interface.

3. The method (350) of claim 1, wherein determining the average discharge rate includes:

retrieving, at the processing device (310), N charge records corresponding to the charging unit (200), each charge record corresponding to a different previous charging session and including a previous charge capacity of the previous charging session and a previous device (20) usage time corresponding to a period of use directly preceding the previous charging session;

for each of the N charge records, determining, at the processing device (310), a previous average discharge rate based on the previous charge capacity and the previous device (20) usage time of the charging record; and

determining, at the processing device (310), the average discharge rate of the battery (202) based on the N previous average discharge rates.

4. The method (350) of claim 1, wherein determining the estimated state of charge (130) includes:

obtaining, at the processing device (310), a fully charged capacity of the battery (202);

determining, by the processing device (310), an estimated amount of discharge of the battery (202) during the period after the most recent charging session based on the average discharge rate and the current device usage time; and

determining, by the processing device (310), the estimated remaining state of charge (130) based on a difference between the fully charged battery (202) capacity and the estimated amount of discharge.

5. The method (350) of claim 1, further comprising:

receiving, at the processing device (310), an event notification (30) indicating a removal time at which the battery (202) was most recently removed from the charger (210); and

determining, by the processing device (310), the current device (20) usage time based on the removal time and a current time.

6. The method (350) of claim 1, wherein providing the estimated state of charge (130) includes transmitting the estimated state of charge (130) from the processing device (310) to the user device (400) over the network (110).

7. The method (350) of claim 1, further comprising, prior to determining the estimated state of charge (130), receiving, at the processing device (310), a charge request (140) from the user device (400), the estimated state of charge (130) determined and provided by the processing device (310) in response to receiving the charge request (140).

8. The method (350) of claim 1, wherein providing the estimated state of charge (130) includes:

determining, by the processing device (310), whether the estimated state of charge (130) is below a state of charge threshold; and

when the estimated state of charge (130) is below the state of charge threshold, transmitting the estimated state of charge (130) from the processing device (310) to the user device (400) over the network (110).

9. A charge server (300) comprising:

a network interface device (326);
a storage device (330);
a processing device (310) coupled to the storage device (330) and the network interface device (326), the processing device (310) being configured to:

receive charge data (120) from a charging unit (200) via a network (110), the charging unit (200) including a charger (210) and the charge data (120) including a charge capacity indicating an amount of charge delivered to a battery (202) during a most recent charging session and a device (20) usage time indicating an amount of time that the battery (202) was off the charger (210) during a period preceding the most recent charging session;

determine an average discharge rate of the battery (202) based on previously received charge data (120) corresponding to the battery (202);

determine an estimated state of charge (130) of the battery (202) based on the average discharge rate and a current device (20) usage time, the current device (20) usage time corresponding to a period after the most recent charging session; and

provide the estimated state of charge (130) to a user device (400) for display.

10. The server (300) of claim 9, wherein the battery (202) is used in a device (20) that does not have a user interface.

11. The server (300) of claim 9, wherein the processing device (310) determines the average discharge rate by:

retrieving N charge records corresponding to the charging unit (200), each charge record corresponding to a different previous charging session and including a previous charge capacity of the previous charging session and a previous device (20) usage time corresponding to a period of use directly preceding the previous charging session;

for each of the N charge records, determining a previous average discharge rate based on the previous charge capacity and the previous device (20) usage time of the charging record; and

determining the average discharge rate of the battery (202) based on the N previous average discharge rates.

12. The server (300) of claim 9, wherein the processing device (310) determines the estimated state of charge (130) by:

obtaining a fully charged capacity of the battery (202);

determining an estimated amount of discharge of the battery (202) during the period after the most recent charging session based on the average discharge rate and the current device (20) usage time; and

determining the estimated remaining state of charge (130) based on a difference between the fully charged battery (202) capacity and the estimated amount of discharge.

13. The server (300) of claim 9, wherein the processing device (310) is further configured to:

receive an event notification (30) indicating a removal time at which the battery (202) was most recently removed from the charger (210); and

determine the current device (20) usage time based on the removal time and a current time.

14. The server (300) of claim 9, wherein the processing device (310) provides the estimated state of charge (130) by transmitting the estimated state of charge (130) to the user device (400) over the network (110).

15. The server (300) of claim 9, wherein the processing device (310) determines the estimated state of charge (130) in response to receiving a charge request (140) from the user device (400).

16. The server (300) of claim 9, wherein the processing device (310) provides the estimated state of charge (130) by:

determining whether the estimated state of charge (130) is below a state of charge threshold; and

when the estimated state of charge (130) is below the state of charge threshold, transmitting the estimated state of charge (130) to the user device (400) over the network (110).

17. A system (100) comprising:

a battery (202);

a charging unit (200) including a charger (210) and a networked device (242), the charging unit (200) being configured to charge the battery (202) and to transmit charge data (120) over a network (110); and

a charge server (300) according to claim 9.

18. The system (100) of claim 17, wherein the estimated state of charge (130) is further based on historical charge data (120).

19. The system (100) of claim 17, wherein the charge server (300) transmits the estimated state of charge (130) in response to a charge request (140) for the estimated state of charge (130) from the user device (400) and/or when the estimated state of charge (130) is less than a predetermined threshold.

20. The method (350) of claim 1, wherein the processing device (310) comprises a processing device (410) of a user device (400), and wherein the method further comprises displaying, by the processing device (410), the estimated state of charge (130) via a user interface (460) of the user device (400).

21. The method (350) of claim 20, wherein the battery (202) is used in a device (20) that does not have a user interface (460).

22. The method (350) of claim 20, wherein determining the average discharge rate includes:

retrieving, by the processing device (410), N charge records corresponding to the charging unit (200), each charge record corresponding to a different previous charging session and including a previous charge capacity of the previous charging session and a previous device (20) usage time corresponding to a period of use directly preceding the previous charging session;
for each of the N charge records, determining, by the processing device (410), a previous average discharge rate based on the previous charge capacity and the previous device (20) usage time of the charging record; and
determining, by the processing device (410), the average discharge rate of the battery (202) based on the N previous average discharge rates.

23. The method (350) of claim 20, wherein determining the estimated state of charge (130) includes:

obtaining, at the processing device (410), a fully charged capacity of the battery (202);
determining, by the processing device (410), an estimated amount of discharge of the battery (202) during the period after the most recent charging session based on the average discharge rate and the current device (20) usage time; and

determining, by the processing device (410), the estimated remaining state of charge (130) based on a difference between the fully charged battery (202) capacity and the estimated amount of discharge.

24. The method (350) of claim 20, further comprising:

receiving, at the processing device (410), an event notification (30) indicating a removal time at which the battery (202) was most recently removed from the charger (210); and
determining, by the processing device (410), the current device (20) usage time based on the removal time and a current time.

25. The method (350) of claim 20, further comprising:

receiving, at the processing device (410), a charge complete signal (38) from the charger (210) when charging of the battery (202) is complete; and
in response to receiving the charge complete signal (38), displaying, by the processing device (410), a charge complete notification (138) via the user interface (460) of the user device (400), the charge complete notification (138) indicating that charging of the battery (202) is complete.

26. The method (350) of claim 20, wherein displaying the estimated state of charge (130) includes:

determining, at the processing device (410), whether the estimated state of charge (130) is below a state of charge threshold; and
displaying the estimated state of charge (130) when the estimated state of charge (130) is below the state of charge threshold.

27. The method (350) of claim 26, further comprising, when the estimated state of charge (130) is below the state of charge threshold, transmitting, by the processing device (410), a low state of charge sound signal (134) to a hearing aid device (20) corresponding to the battery (202), the hearing aid device (20) configured to audibly alert a user (10) wearing the hearing aid device (20) in response to receiving the low state of charge sound signal (134).

28. The method (350) of claim 20, further comprising:

storing, by the processing device (410), a notification time set by a user of the user device (400) in a storage device (490), the notification time indicating a time to charge the battery (202); and

when the charger (210) is not charging the battery (202) at the notification time:

displaying, by the processing device (410), a reminder notification (132) via the user interface (460) of the user device (400); and/or

transmitting, by the processing device (410), a charging reminder sound signal (136) to a hearing aid device (20) corresponding to the battery (202), the hearing aid device (20) configured to audibly remind a user (10) wearing the hearing aid device (20) to charge the battery (202) in response to receiving the charging reminder sound signal (136).

29. The method (350) of claim 20, wherein the battery (202) corresponds to a hearing aid device (20) that operates in a hearing aid mode and a wireless streaming mode, whereby the user device (400) streams sound signals to the hearing aid device (20) during the wireless streaming mode; and wherein determining the estimated state of charge (130) of the battery (202) includes:

determining a first amount of time that the hearing aid device (20) operates in the wireless streaming mode during the period after the most recent charging session;

determining an estimated wireless drain indicating an estimated amount of charge drained from the battery (202) during operation in the wireless mode;

determining a second amount of time that the hearing aid device (20) operates in in the hearing aid mode;

determining an estimated hearing aid drain indicating an estimated amount of charge drained from the battery (202) during operation in the hearing aid mode; and

determining the estimated state of charge (130) based on the charge capacity, the estimated wireless drain, and the estimated hearing aid drain.

**Patentansprüche**

1. Ein Verfahren (350), welches das:

- Empfangen von Ladungswerten (120) von einer Ladeeinheit (200) in einer Verarbeitungseinrichtung (310) über ein Netzwerk (110), wobei die Ladeeinheit (200) ein Ladegerät (210) umfasst und die Ladungswerte (120) die Ladungskapazität, welche die während des jüngst vergangenen Ladungsvorgangs einer Batterie (202) gelieferte Ladungsmenge anzeigt, und den Benutzungszeitraum eines Geräts (20), der den Zeitraum, innerhalb welchen die Batterie (202) während des Zeitraums, der dem jüngsten Ladungsvorgang vorherging, von dem Ladegerät (210) getrennt war, anzeigt, umfassen,

- Bestimmen der durchschnittlichen Entladungsgeschwindigkeit der Batterie (202) basierend auf den zuvor empfangenen Ladungswerten (120), die der Batterie (202) entsprechen, durch die Verarbeitungseinrichtung (310),

- Bestimmen des geschätzten Ladungszustands (130) der Batterie (202) basierend auf der durchschnittlichen Entladungsgeschwindigkeit und dem aktuellen Benutzungszeitraum des Geräts (20), der dem Zeitraum nach dem jüngsten Ladungsvorgang entspricht, durch die Verarbeitungseinrichtung (310) und

- Liefern des geschätzten Ladungszustands (130) durch die Verarbeitungseinrichtung (310) an ein Benutzergerät (400), um ihn dort anzuzeigen,

umfasst.

2. Das Verfahren (350) nach Anspruch 1, wobei die Batterie (202) in einem Gerät (20), das keine Benutzerschnittstelle besitzt, verwendet wird.

3. Das Verfahren (350) nach Anspruch 1, wobei die Bestimmung der durchschnittlichen Entladungsgeschwindigkeit das:

- Auffinden von N der Ladeeinheit (200) entsprechenden Ladungsregistrierungen in der Verarbeitungseinrichtung (310), wobei jede Ladungsregistrierung einem anderen vorhergegangenen Ladungsvorgang entspricht und die vorhergehende Ladungskapazität des vorhergegangenen Ladungsvorgangs und den vorhergehenden Benutzungszeitraum des Geräts (20), der dem Benutzungszeitraum entspricht, der dem vorhergegangenen Ladungsvorgang direkt vorhergegangen war, umfasst,
- Bestimmen der vorhergehenden durchschnittlichen Entladungsgeschwindigkeit basierend auf der vorhergehenden Ladungskapazität und dem vorhergehenden Benutzungszeitraum des Geräts (20) der Ladungsregistrierung für jede der N Ladungsregistrierungen in der Verarbeitungseinrichtung (310) und
- Bestimmen der durchschnittlichen Entladungsgeschwindigkeit der Batterie (202) basierend auf den N vorhergehenden durchschnittlichen Entladungsgeschwindigkeiten in der Verarbeitungseinrichtung (310)

umfasst.

4. Das Verfahren (350) nach Anspruch 1, wobei die Bestimmung des geschätzten Ladungszustands (130) das:

- Erreichen der vollen Ladungskapazität der Batterie (202) in der Verarbeitungseinrichtung (310),
- Bestimmen des geschätzten Entladungszustands der Batterie (202) durch die Verarbeitungseinrichtung (310) während des Zeitraums nach dem jüngsten Ladungsvorgang basierend auf der durchschnittlichen Entladungsgeschwindigkeit und dem aktuellen Benutzungszeitraum des Geräts und
- Bestimmen des geschätzten restlichen Ladungszustands (130) basierend auf der Differenz zwischen der Kapazität der vollständig aufgeladenen Batterie (202) und dem geschätzten Entladungszustand durch die Verarbeitungseinrichtung (310)

umfasst.

5. Das Verfahren (350) nach Anspruch 1, welches weiterhin das:

- Empfangen einer Mitteilung (30) über ein Ereignis, welche die Entnahmezeit anzeigt, zu welcher die Batterie (202) jüngst aus dem Ladegerät (210) entnommen worden ist, in der Verarbeitungseinrichtung (310) und
- Bestimmen des aktuellen Benutzungszeitraums des Geräts (20) basierend auf der Zeit der Entnahme und der aktuellen Zeit durch die Verarbeitungseinrichtung (310)

umfasst.

6. Das Verfahren (350) nach Anspruch 1, wobei das Liefern des geschätzten Ladungszustands (130) die Übertragung des geschätzten Ladungszustands (130) von der Verarbeitungseinrichtung (310) zu dem Benutzergerät (400) über das Netzwerk (110) umfasst.

7. Das Verfahren (350) nach Anspruch 1, welches ferner vor der Bestimmung des geschätzten Ladungszustands (130) das Empfangen einer Ladungsanforderung (140) vom Benutzergerät (400) in der Verarbeitungseinrichtung (310) umfasst, wobei der geschätzte Ladungszustand (130) von der Verarbeitungseinrichtung (310) als Reaktion auf das Empfangen der Ladungsanforderung (140) bestimmt und geliefert wird.

8. Das Verfahren (350) nach Anspruch 1, wobei das Liefern des geschätzten Ladungszustands (130) das:

- Bestimmen, ob der geschätzte Ladungszustand (130) sich unterhalb einer Grenze des Ladungszustands befindet, durch die Verarbeitungseinrichtung (310) und, wenn der geschätzte Ladungszustand (130) sich unterhalb der Grenze des Ladungszustands befindet,
- Übertragen des geschätzten Ladungszustands (130) von der Verarbeitungseinrichtung (310) zu dem Benutzergerät (400) über das Netzwerk (110) umfasst.

9. Ein Ladeserver (300), der:

- eine Netzwerkschnittstelle (326),
- ein Speichergerät (330) und
- eine Verarbeitungseinrichtung (310), die mit dem Speichergerät (330) und der Netzwerkschnittstelle (326) gekoppelt ist, umfasst, wobei die Verarbeitungseinrichtung (310) so konfiguriert ist, dass sie:

• Ladungswerte (120) von einer Ladeeinheit (200) über ein Netzwerk (110) empfängt, wobei die Ladeeinheit (200) ein Ladegerät (210) umfasst und die Ladungswerte (120) die Ladungskapazität, welche die während des jüngst vergangenen Ladungsvorgangs einer Batterie (202) gelieferte Ladungsmenge anzeigt, und den Benutzungszeitraum des Geräts (20), der den Zeitraum, innerhalb welchen die Batterie (202) während des Zeitraums, der dem jüngsten Ladungsvorgang vorherging, von dem Ladegerät (210) getrennt war, anzeigt, umfassen,

• die durchschnittliche Entladungsgeschwindigkeit der Batterie (202) basierend auf den zuvor empfangenen Ladungswerten (120), die der Batterie (202) entsprechen, bestimmt,

• den geschätzten Ladungszustand (130) der Batterie (202) basierend auf der durchschnittlichen Entladungsgeschwindigkeit und dem aktuellen Benutzungszeitraum des Geräts (20) bestimmt, wobei der aktuelle Benutzungszeitraum des Geräts (20) dem Zeitraum nach dem jüngsten Ladungsvorgang entspricht, und

• den geschätzten Ladungszustand (130) einem Benutzergerät (400), um ihn dort anzuzeigen, liefert.

10. Der Ladeserver (300) nach Anspruch 9, wobei die Batterie (202) in einem Gerät (20), das keine Nutzerschnittstelle besitzt, verwendet wird.

11. Der Ladeserver (300) nach Anspruch 9, wobei von der Verarbeitungseinrichtung (310) die durchschnittliche Entladungsgeschwindigkeit durch das:

- Auffinden von N der Ladeeinheit (200) entsprechenden Ladungsregistrierungen, wobei jede Ladungsregistrierung einem anderen vorhergegangenen Ladungsvorgang entspricht und die vorhergehende Ladungskapazität des vorhergegangenen Ladungsvorgangs und den vorhergehenden Benutzungszeitraum des Geräts (20), der dem Benutzungszeitraum entspricht, der dem vorhergegangenen Ladungsvorgang direkt vorhergegangen war, umfasst,

- Bestimmen der vorhergehenden durchschnittlichen Entladungsgeschwindigkeit basierend auf der vorhergehenden Ladungskapazität und dem vorhergehenden Benutzungszeitraum des Geräts (20) der Ladungsregistrierung für jede der N Ladungsregistrierungen und

- Bestimmen der durchschnittlichen Entladungsgeschwindigkeit der Batterie (202) basierend auf den N vorhergehenden durchschnittlichen Entladungsgeschwindigkeiten

bestimmt wird.

12. Der Ladeserver (300) nach Anspruch 9, wobei von der Verarbeitungseinrichtung (310) der geschätzte Ladungszustand (130) durch das:

- Erreichen der vollen Ladungskapazität der Batterie (202),

- Bestimmen des geschätzten Entladungszustands der Batterie (202) während des Zeitraums nach dem jüngsten Ladungsvorgang basierend auf der durchschnittlichen Entladungsgeschwindigkeit und dem aktuellen Benutzungszeitraum des Geräts (20) und

- Bestimmen des geschätzten restlichen Ladungszustands (130) basierend auf der Differenz zwischen der Kapazität der vollständig aufgeladenen Batterie (202) und dem geschätzten Entladungszustand

bestimmt wird.

13. Der Ladeserver (300) nach Anspruch 9, wobei die Verarbeitungseinrichtung (310) weiterhin so konfiguriert ist, dass sie:

- eine Mitteilung (30) über ein Ereignis, welche die Entnahmezeit anzeigt, zu welcher die Batterie (202) jüngst aus dem Ladegerät (210) entnommen worden ist, empfängt und

- den aktuellen Benutzungszeitraums des Geräts (20) basierend auf der Zeit der Entnahme und der aktuellen Zeit bestimmt.

14. Der Ladeserver (300) nach Anspruch 9, wobei die Verarbeitungseinrichtung (310) den geschätzten Ladungszustands (130) durch die Übertragung des geschätzten Ladungszustands (130) zu dem Benutzergerät (400) über das Netzwerk (110) liefert.

15. Der Ladeserver (300) nach Anspruch 9, wobei der geschätzte Ladungszustand (130) als Reaktion auf das Empfangen einer Ladungsanforderung (140) von dem Benutzergerät (400) von der Verarbeitungseinrichtung (310) bestimmt wird.

16. Der Ladeserver (300) nach Anspruch 9, wobei von der Verarbeitungseinrichtung (310) der geschätzte Ladungszustand (130) durch:

   - Bestimmen, ob der geschätzte Ladungszustand (130) sich unterhalb der Grenze des Ladungszustands befindet, und wenn sich der geschätzte Ladungszustand (130) unterhalb der Grenze des Ladungszustands befindet,
   - Übertragen des geschätzten Ladungszustands (130) zu dem Benutzergerät (400) über das Netzwerk (110)

   geliefert wird.

17. Ein System (100), das:

   - eine Batterie (202),
   - eine Ladeeinheit (200), einschließlich eines Ladegeräts (210) und eines Netzwerkgeräts (242), wobei die Ladeeinheit (200) so konfiguriert ist, dass sie die Batterie (202) auflädt und die Ladungswerte (120) über ein Netzwerk (110) überträgt, und
   - einen Ladeserver (300) nach Anspruch 9

   umfasst.

18. Das System (100) nach Anspruch 17, wobei der geschätzte Ladungszustand (130) weiterhin auf den historischen Ladungswerten (120) basiert.

19. Das System (100) nach Anspruch 17, wobei von dem Ladeserver (300) der geschätzte Ladungszustand (130) als Reaktion auf eine Ladungsanforderung (140) für den geschätzten Ladungszustand (130) von dem Benutzergerät (400) und/oder wenn der geschätzte Ladungszustand (130) niedriger als eine festgelegte Grenze ist, übertragen wird.

20. Das Verfahren (350) nach Anspruch 1, wobei die Verarbeitungseinrichtung (310) eine Verarbeitungseinrichtung (410) eines Benutzergeräts (400) umfasst und das Verfahren darüber hinaus das Anzeigen des geschätzten Ladungszustands (130) über eine Benutzerschnittstelle (460) des Benutzergeräts (400) durch die Verarbeitungseinrichtung (410) umfasst.

21. Das Verfahren (350) nach Anspruch 20, wobei die Batterie (202) in einem Gerät verwendet wird, das keine Benutzerschnittstelle (460) besitzt.

22. Das Verfahren (350) nach Anspruch 20, wobei die Bestimmung der durchschnittlichen Entladungsgeschwindigkeit das:

   - Auffinden von N der Ladeeinheit (200) entsprechenden Ladungsregistrierungen durch die Verarbeitungseinrichtung (410), wobei jede Ladungsregistrierung einem anderen vorhergegangenen Ladungsvorgang entspricht und die vorhergehende Ladungskapazität des vorhergegangenen Ladungsvorgangs und den vorhergehenden Benutzungszeitraum des Geräts (20), der dem Benutzungszeitraum entspricht, der dem vorhergegangenen Ladungsvorgang direkt vorhergegangen war, umfasst,
   - Bestimmen der vorhergehenden durchschnittlichen Entladungsgeschwindigkeit basierend auf der vorhergehenden Ladungskapazität und dem vorhergehenden Benutzungszeitraum des Geräts (20) der Ladungsregistrierung für jede der N Ladungsregistrierungen durch die Verarbeitungseinrichtung (410) und
   - Bestimmen der durchschnittlichen Entladungsgeschwindigkeit der Batterie (202) basierend auf den N vorhergehenden durchschnittlichen Entladungsgeschwindigkeiten durch die Verarbeitungseinrichtung (410)

   umfasst.

23. Das Verfahren (350) nach Anspruch 20, wobei die Bestimmung des geschätzten Ladungszustands (130) das:

   - Erreichen der vollen Ladungskapazität der Batterie (202) in der Verarbeitungseinrichtung (410),

- Bestimmen des geschätzten Entladungszustands der Batterie (202) durch die Verarbeitungseinrichtung (410) während des Zeitraums nach dem jüngsten Ladungsvorgang basierend auf der durchschnittlichen Entladungsgeschwindigkeit und dem aktuellen Benutzungszeitraum des Geräts (20) und
- Bestimmen des geschätzten restlichen Ladungszustands (130) basierend auf der Differenz zwischen der Kapazität der vollständig aufgeladenen Batterie (202) und dem geschätzten Entladungszustand durch die Verarbeitungseinrichtung (410) umfasst.

24. Das Verfahren (350) nach Anspruch 20, welches außerdem das:

- Empfangen einer Mitteilung (30) über ein Ereignis, welche die Entnahmezeit anzeigt, zu welcher die Batterie (202) jüngst aus dem Ladegerät (210) entnommen worden ist, in der Verarbeitungseinrichtung (410) und
- Bestimmen des aktuellen Benutzungszeitraums des Geräts (20) basierend auf der Entnahmezeit und der aktuellen Zeit durch die Verarbeitungseinrichtung (410)

umfasst.

25. Das Verfahren (350) nach Anspruch 20, welches zusätzlich das:

- Empfangen eines Signals (38) über die vollständige Aufladung von dem Ladegerät (210), wenn das Aufladen der Batterie (202) vollständig ist, in der Verarbeitungseinrichtung (410) und
- Anzeigen einer Mitteilung (138) über die vollständige Aufladung über die Benutzerschnittstelle (460) des Benutzergeräts (400) durch die Verarbeitungseinrichtung (410) als Reaktion auf das Empfangen des Signals (38) über die vollständige Aufladung umfasst, wobei die Mitteilung (138) über die vollständige Aufladung anzeigt, dass das Aufladen der Batterie (202) vollständig ist.

26. Das Verfahren (350) nach Anspruch 20, wobei das Anzeigen des geschätzten Ladungszustands (130) das:

- Bestimmen, ob der geschätzte Ladungszustand (130) sich unterhalb einer Grenze des Ladungszustands befindet, in der Verarbeitungseinrichtung (410) und
- Anzeigen des geschätzten Ladungszustands (130), wenn der geschätzte Ladungszustand (130) sich unterhalb der Grenze des Ladungszustands befindet,

umfasst.

27. Das Verfahren (350) nach Anspruch 26, welches weiterhin, wenn der geschätzte Ladungszustand (130) sich unterhalb der Grenze des Ladungszustands befindet, die Übertragung eines einen niedrigen Ladungszustand anzeigenden akustischen Signals (134) durch die Verarbeitungseinrichtung (410) an ein Hörgerät (20), das der Batterie (202) entspricht, umfasst, wobei das Hörgerät (20) so konfiguriert ist, dass es einen Träger (10), der das Hörgerät (20) trägt, als Reaktion auf den Empfang des einen niedrigen Ladungszustand anzeigenden akustischen Signals (134) hörbar warnt.

28. Das Verfahren (350) nach Anspruch 20, welches ferner das:

- Speichern einer Mitteilungszeit, die von dem Benutzer des Benutzergeräts (400) eingestellt wird, durch die Verarbeitungseinrichtung (410) in einer Speichereinrichtung (490), wobei von der Mitteilungszeit der Zeitpunkt zum Aufladen der Batterie (202) angezeigt wird, und, wenn das Ladegerät (210) die Batterie (202) zur Mitteilungszeit nicht auflädt:
- Anzeigen einer Erinnerungsmitteilung (132) durch die Verarbeitungseinrichtung (410) über die Benutzerschnittstelle (460) des Benutzergeräts (400) und/oder
- Übertragen eines an das Aufladen erinnernden akustischen Signals (136) durch die Verarbeitungseinrichtung (410) zu einem Hörgerät (20), das der Batterie (202) entspricht, wobei das Hörgerät (20) so konfiguriert ist, dass es den Träger (10), der das Hörgerät (20) trägt, hörbar daran erinnert, die Batterie (202) als Reaktion auf den Empfang des an das Aufladen erinnernden akustischen Signals (136) wieder aufzuladen,

umfasst.

29. Das Verfahren (350) nach Anspruch 20, wobei die Batterie (202) einem Hörgerät (20) entspricht, das in einem den Hörvorgang verbessernden Modus und einem drahtlosen Übertragungsmodus betrieben wird, wodurch während des drahtlosen Übertragungsmodus von dem Benutzergerät (400) akustische Signale zu dem Hörgerät (20) übertragen werden und wobei das Bestimmen des geschätzten Ladungszustands (130) der Batterie (202) das:

- Bestimmen eines ersten Zeitraums, innerhalb welchen das Hörgerät (20) in dem drahtlosen Übertragungsmodus während des Zeitraums nach dem jüngsten Ladungsvorgang betrieben wird,
- Bestimmen der geschätzten drahtlosen Entnahme, die die geschätzte Ladungsmenge anzeigt, die während des Betriebs im drahtlosen Modus der Batterie (202) entnommen worden ist,
- Bestimmen eines zweiten Zeitraums, innerhalb welchen das Hörgerät (20) in dem den Hörvorgang verbessernden Modus betrieben wird,
- Bestimmen der geschätzten Entnahme des Hörgeräts, die die geschätzte Ladungsmenge anzeigt, die während des Betriebs in dem den Hörvorgang verbessernden Modus der Batterie (202) entnommen worden ist, und
- Bestimmen des geschätzten Ladungszustands (130) basierend auf der Ladungskapazität, der geschätzten drahtlosen Entnahme und der geschätzten Entnahme des Hörgeräts

umfasst.

**Revendications**

1.  Procédé (350) comprenant :

    la réception par un dispositif de traitement (310), de données de charge (120) à partir d'une unité de charge (200) via un réseau (110), l'unité de charge (200) comprenant un chargeur (210) et les données de charge (120) comprenant une capacité de charge indiquant la quantité de charge fournie à la batterie (202) au cours de la session de chargement la plus récente et une période d'utilisation du dispositif (20) indiquant la période pendant laquelle la batterie (202) était déconnectée du chargeur (210) pendant la période précédant la session de chargement la plus récente ;
    la détermination par le dispositif de traitement (310), d'un taux moyen de décharge de la batterie (202) sur base des données de charge (120) reçues précédemment correspondant à la batterie (202) ;
    la détermination par le dispositif de traitement (310), d'un état de charge estimé (130) de la batterie (202) sur base du taux moyen de décharge et de la période d'utilisation actuelle du dispositif (20), la période d'utilisation actuelle du dispositif (20) correspondant à la période après la session de chargement la plus récente, et
    la mise à disposition par le dispositif de traitement (310), de l'état de charge estimé (130) pour un dispositif utilisateur (400) pour affichage.

2.  Procédé (350) selon la revendication 1, où la batterie (202) est utilisée dans un dispositif (20) qui ne présente pas d'interface utilisateur.

3.  Procédé (350) selon la revendication 1, où la détermination du taux moyen de décharge comprend :

    l'extraction du dispositif de traitement (310), de N enregistrements de charge correspondant à l'unité de charge (200), chaque enregistrement de charge correspondant à une session de chargement précédente différente et incluant une capacité de charge précédente de la session de charge précédente et d'une utilisation précédente du dispositif de charge (20) correspondant à la période d'utilisation précédant directement la session de charge précédente ;
    pour chacun des N enregistrements de charge, la détermination par le dispositif de traitement (310), d'un taux moyen de décharge précédent sur base de la capacité de charge précédente et de la période d'utilisation précédente du dispositif (20) de l'enregistrement de charge, et
    la détermination par le dispositif de traitement (310), du taux de déchargement moyen de la batterie (202) sur base des N taux moyens de décharge précédents.

4.  Procédé (350) selon la revendication 1, où la détermination de l'état de charge estimé (130) comprend :

    l'obtention par le dispositif de traitement (310) d'une capacité de charge complète de la batterie (202) ;
    la détermination par le dispositif de traitement (310), d'une quantité estimée de décharge de la batterie (202) pendant la période suivant la session de chargement la plus récente sur base du taux moyen de décharge et de la période d'utilisation actuelle du dispositif, et
    la détermination par le dispositif de traitement (310), de l'état de charge (130) restant estimé sur base de la différence entre la capacité de charge complète de la batterie (202) et la quantité estimée de décharge.

5. Procédé (350) selon la revendication 1, comprenant en outre :

la réception par le dispositif de traitement (310), d'une notification d'événement (30) indiquant une période de retrait à laquelle la batterie (202) a été retirée le plus récemment du chargeur (210), et
la détermination par le dispositif de traitement (310), de la période d'utilisation actuelle du dispositif (20) sur base de la période de retrait et de la période actuelle.

6. Procédé (350) selon la revendication 1, où la mise à disposition de l'état de charge estimé (130) comprend la transmission de l'état de charge estimé (130) du dispositif de traitement (310) au dispositif utilisateur (400) par le réseau (110).

7. Procédé (350) selon la revendication 1, comprenant en outre, avant la détermination de l'état de charge estimé (130), la réception par le dispositif de traitement (310), d'une requête de charge (140) du dispositif utilisateur (400), de l'état de charge estimé (130) déterminé et la mise à disposition par le dispositif de traitement (310) en réponse à la réception de la requête de charge (140).

8. Procédé (350) selon la revendication 1, où la mise à disposition de l'état de charge estimé (130) comprend :

la détermination par le dispositif de traitement (310), si l'état de charge estimé (130) est inférieur à un état de charge seuil, et
lorsque l'état de charge estimé (130) est inférieur à l'état de charge seuil, la transmission de l'état de charge estimé (130) du dispositif de traitement (310) au dispositif utilisateur (400) par le réseau (110).

9. Serveur de charge (300) comprenant :

un dispositif d'interface de réseau (326) ;
un dispositif de stockage (330) ;
un dispositif de traitement (310) couplé au dispositif de stockage (330) et au dispositif d'interface de réseau (326), le dispositif de traitement (310) étant configuré pour :

recevoir des données de charge (120) depuis une unité de chargement (200) via le réseau (110), l'unité de chargement (200) comprenant un chargeur (210) et les données de charge (120) comprenant une capacité de charge indiquant la quantité de charge fournie à la batterie (202) au cours de la session de chargement la plus récente et une période d'utilisation du dispositif (20) indiquant la période pendant laquelle la batterie (202) était déconnectée du chargeur (210) pendant la période précédant la session de chargement la plus récente ;
déterminer un taux moyen de décharge de la batterie (202) sur base des données de charge (120) reçues précédemment correspondant à la batterie (202) ;
déterminer un état de charge estimé (130) de la batterie (202) sur base du taux moyen de décharge et de la période d'utilisation actuelle du dispositif (20), la période d'utilisation actuelle du dispositif (20) correspondant à la période après la session de chargement la plus récente, et
mettre à disposition l'état de charge estimé (130) pour un dispositif utilisateur (400) pour affichage.

10. Serveur (100) selon la revendication 9, où la batterie (202) est utilisée dans un dispositif (20) qui ne présente pas d'interface utilisateur.

11. Serveur (100) selon la revendication 9, où le dispositif de traitement (310) détermine le taux moyen de décharge par :

l'extraction de N enregistrements de charge correspondant à l'unité de charge (200), chaque enregistrement de charge correspondant à une session de chargement précédente différente et incluant une capacité de charge précédente de la session de charge précédente et d'une période d'utilisation précédente du dispositif de charge (20) correspondant à la période d'utilisation précédant directement la session de charge précédente ;
pour chacun des N enregistrements de charge, la détermination d'un taux moyen de décharge précédent sur base de la capacité de charge précédente et de la période d'utilisation précédente du dispositif (20) de l'enregistrement de charge, et
la détermination du taux de déchargement moyen de la batterie (202) sur base des N taux moyens de décharge précédents.

**12.** Serveur (300) selon la revendication 9, où le dispositif de traitement (310) détermine l'état de charge estimé (130) par :

l'obtention d'une capacité de charge complète de la batterie (202) ;
la détermination d'une quantité estimée de décharge de la batterie (202) pendant la période suivant la session de chargement la plus récente sur base du taux moyen de décharge et de la période d'utilisation actuelle du dispositif, et
la détermination de l'état de charge (130) restant estimé sur base de la différence entre la capacité de charge complète de la batterie (202) et la quantité estimée de décharge.

**13.** Serveur (300) selon la revendication 9, où le dispositif de traitement (310) est configuré en outre, pour :

recevoir une notification d'événement (30) indiquant une période de retrait à laquelle la batterie (202) a été retirée le plus récemment du chargeur (210), et
déterminer la période d'utilisation actuelle du dispositif (20) sur base de la période de retrait et de la période actuelle.

**14.** Serveur (300) selon la revendication 9, où le dispositif de traitement (310) fournit l'état de charge estimé (130) par la transmission de l'état de charge estimé (130) au dispositif utilisateur (400) par le réseau (110).

**15.** Serveur (300) selon la revendication 9, où le dispositif de traitement (310) détermine l'état de charge estimé (130) en réponse à la réception d'une requête de charge (140) depuis le dispositif utilisateur (400).

**16.** Serveur (300) selon la revendication 9, où le dispositif de traitement (310) fournit l'état de charge estimé (130) par :

la détermination si l'état de charge estimé (130) est inférieur à un état de charge seuil, et
lorsque l'état de charge estimé (130) est inférieur à l'état de charge seuil, la transmission de l'état de charge estimé (130) au dispositif utilisateur (400) par le réseau (110).

**17.** Système (100) comprenant :

une batterie (202) ;
une unité de charge (200) comprenant un chargeur (210) et un dispositif en réseau (242), l'unité de charge (200) étant configurée pour charger la batterie (202) et transmettre les données de charge (120) par le réseau (110), et
un serveur de charge (300) selon la revendication 9.

**18.** Système (100) selon la revendication 17, où l'état de charge estimé (130) est basé en outre, sur les données de charge historiques (120).

**19.** Système (100) selon la revendication 17, où le serveur de charge (300) transmet l'état de charge estimé (130) en réponse à une requête de charge (140) pour l'état de charge estimé (130) depuis le dispositif utilisateur (400) et/ou lorsque l'état de charge estimé (130) est inférieur à un seuil prédéterminé.

**20.** Procédé (350) selon la revendication 1, où le dispositif de traitement (310) comprend un dispositif de traitement (410) d'un dispositif utilisateur (400), et où le procédé comprend en outre, l'affichage par le dispositif de traitement (410) de l'état de charge estimé (130) via une interface utilisateur (460) du dispositif utilisateur (400).

**21.** Procédé (350) selon la revendication 20, où le la batterie (202) est utilisée dans un dispositif (20) qui ne doit pas avoir d'interface utilisateur (460).

**22.** Procédé (350) selon la revendication 20, où la détermination du taux moyen de décharge comprend :

l'extraction par dispositif de traitement (410), de N enregistrements de charge correspondant à l'unité de charge (200), chaque enregistrement de charge correspondant à une session de chargement précédente différente et incluant une capacité de charge précédente de la session de charge précédente et d'une utilisation précédente du dispositif de charge (20) correspondant à la période d'utilisation précédant directement la session de charge précédente ;

pour chacun des N enregistrements de charge, la détermination par le dispositif de traitement (410), d'un taux moyen de décharge précédent sur base de la capacité de charge précédente et de la période d'utilisation précédente du dispositif (20) de l'enregistrement de charge, et

la détermination par le dispositif de traitement (410), du taux de déchargement moyen de la batterie (202) sur base des N taux moyens de décharge précédents.

23. Procédé (350) selon la revendication 20, où la détermination de l'état de charge estimé (130) comprend :

l'obtention par le dispositif de traitement (410), d'une capacité de charge complète de la batterie (202) ;

la détermination par le dispositif de traitement (410), d'une quantité estimée de décharge de la batterie (202) pendant la période suivant la session de chargement la plus récente sur base du taux moyen de décharge et de la période d'utilisation actuelle du dispositif (20), et

la détermination par le dispositif de traitement (410), de l'état de charge estimé (130) sur base de la différence entre la capacité de charge complète de la batterie (202) et la quantité estimée de décharge.

24. Procédé (350) selon la revendication 20, comprenant en outre :

la réception par le dispositif de traitement (410), d'une notification d'événement (30) indiquant une période de retrait à laquelle la batterie (202) a été retirée le plus récemment du chargeur (210), et

la détermination par le dispositif de traitement (410), de la période d'utilisation actuelle du dispositif (20) sur base de la période de retrait et de la période actuelle.

25. Procédé (350) selon la revendication 20, comprenant en outre :

la réception par le dispositif de traitement (410), d'un signal de charge complète (38) du chargeur (210) lorsque le chargement de la batterie (202) est complet, et

en réponse à la réception du signal de charge complète (38), l'affichage par le dispositif de traitement (410), d'une notification de charge complète (138) via l'interface utilisateur (460) du dispositif utilisateur (400), la notification de charge complète (138) indiquant que le chargement de la batterie (202) est terminé.

26. Procédé (350) selon la revendication 20, où l'affichage de l'état de charge estimé (130) comprend :

la détermination par le dispositif de traitement (410), si l'état de charge estimé (130) est inférieur à un état de charge seuil, et

lorsque l'état de charge estimé (130) est inférieur à l'état de charge seuil, l'affichage de l'état de charge (130).

27. Procédé (350) selon la revendication 26, comprenant en outre, lorsque l'état de charge estimé (130) est inférieur à l'état de charge seuil, la transmission par le dispositif de traitement (410), d'un signal sonore d'état de faible charge (134) à un dispositif d'aide auditive (20) correspondant à la batterie (202), le dispositif d'aide auditive (20) étant configuré pour alerter de manière audible un utilisateur (10) portant le dispositif d'aide auditive (20) en réponse à la réception du signal sonore d'état de faible charge (134).

28. Procédé (350) selon la revendication 20, comprenant en outre :

le stockage, par le dispositif de traitement (410), d'un réglage temporel de notification par un utilisateur du dispositif utilisateur (400) dans un dispositif de stockage (490), l'heure de notification indiquant le moment de chargement de la batterie (202), et

lorsque le chargeur (210) ne charge pas la batterie (202) à l'heure de notification :

l'affichage par le dispositif de traitement (410) d'une notification de rappel (132) via l'interface utilisateur (460) du dispositif utilisateur (400) ; et/ou

la transmission par le dispositif de traitement (410) d'un signal sonore de rappel de charge (136) au dispositif d'aide auditive (20) correspondant à la batterie (202), le dispositif d'aide auditive (20) étant configuré pour émettre un rappel audible à l'utilisateur (10) portant le dispositif d'aide auditive (20) pour charger la batterie (202) en réponse à la réception du signal sonore de rappel de charge (136) .

29. Procédé (350) selon la revendication 20, où la batterie (202) correspond à un dispositif d'aide auditive (20) qui fonctionne en mode aide auditive et en mode sans fil, où le dispositif utilisateur (400) envoie des signaux sonores vers le dispositif d'aide auditive (20) pendant le mode sans fil, et où la détermination de l'état de charge estimé (130) de la batterie (202) comprend :

la détermination d'une première quantité de temps pendant laquelle le dispositif d'aide auditive (20) fonctionne en mode sans fil pendant la période après la session de chargement la plus récente ;

la détermination d'une perte sans fil estimée indiquant une quantité estimée de charge perdue par la batterie (202) pendant le fonctionnement en mode sans fil ;

la détermination d'une deuxième quantité de temps pendant laquelle le dispositif d'aide auditive (20) fonctionne en mode aide auditive ;

la détermination d'une perte d'aide auditive estimée indiquant une quantité estimée de charge perdue par la batterie (202) pendant le fonctionnement en mode aide auditive ; et

la détermination de l'état de charge estimé (130) sur base de la capacité de charge, de la perte sans fil estimée et de la perte aide auditive estimée.

FIG. 1A

**FIG. 1B**

FIG. 2A

FIG. 2B

EP 3 117 229 B1

100

300

330  332

310  312

Charge Data
Database

Data
Recording
Application

Storage Device

314

326

Network
Interface
Device

Charge
Status
Application

Processing
Device

110

**Network**

# FIG. 3A

350

Start

360

Retrieve One Or More Charge Records Corresponding To The Charger

362

Calculate A Discharge Rate For The Battery

364

Calculate An Amount Of Charge Used Based On The Discharge Rate And A Current Wear Time

366

Calculate A State Of Charge Based On The Amount Of Charge Used And A Total Capacity Of The Battery

368

Report The State Of Charge To A User Device

End

FIG. 3B

400b, 400 →

┌─────────────────────────────┐
│  .ıllı Wireless Provider  D    ▮▮▮▯ │
│  ┌───────────────────────┐  │
│  │              430        │  │
│  │  Hearing Aid In Use     │  │
│  │  Hearing Only: 16 Hr 40 Min │
│  │  Wireless Audio: 5 Hr 2 Min │
│  │                         │  │
│  │            ⌐130         │  │
│  │        ┌───────┐        │  │
│  │        │       │        │  │
│  │        │  18%  │        │  │
│  │        └───────┘        │  │
│  │      Battery State Of   │  │
│  │           Charge        │  │
│  └───────────────────────┘  │
└─────────────────────────────┘

FIG. 4A

400b, 400 →

┌─────────────────────────────┐
│  .ıllı Wireless Provider  D    ▮▮▮▯ │
│  ┌───────────────────────┐  │
│  │              430        │  │
│  │  Hearing Aid Charging   │  │
│  │                         │  │
│  │  2 Hr 11 Min Remaining  │  │
│  │                         │  │
│  │            ⌐130         │  │
│  │        ┌───────┐        │  │
│  │        │       │        │  │
│  │        │  72%  │        │  │
│  │        └───────┘        │  │
│  │      Battery State Of   │  │
│  │           Charge        │  │
│  └───────────────────────┘  │
└─────────────────────────────┘

FIG. 4B

EP 3 117 229 B1

400,
400a

430

Reminder: It
is time to
charge the
battery.

132

460

136

Charging
Reminder Sound

20

Hearing Aid Device

10

User

## FIG. 5A

400,
400a

430

Warning!
Battery State
of Charge is
9%
Charge Soon

130

460

134

Low SOC Sound

20

Hearing Aid Device

10

User

## FIG. 5B

400a,
400

460

⏸ 2:22 PM

Menu 600a

602a  604a  606a

Connection | Batteries | Finder

My Places — 608a

My Hearing Aid — 610a

Tutorial — 612a

Settings — 614a

FIG. 6A

EP 3 117 229 B1

400a,
400

460

⏸️📶🔋 2:22 PM

## Configuration 600b   Back

| Health Care Provider | — 602b |

| Office Phone (123) 555-1234 | — 604b |

| Hearing Aid Brand | — 606b |

| Hearing Aid Model | — 608b |

Charger Serial Number

| 543GH44FF32P112 | — 610b |

| Forget This Charger | — 612b |

Share data with
Healthcare Provider?          — 614b

## FIG. 6B

400a,
400

460

📶🔋 2:22 PM

## Alerts 600c   Back

10:30PM
Charge Reminder                — 602c

Charge Complete
Notification                   — 604c

## Low Battery Notification

Audible Notifications          — 606c

10% State Of Charge            — 608c

20% State Of Charge            — 610c

30% State Of Charge            — 612c

## FIG. 6C

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012130660 A